(19) **Europäisches Patentamt / European Patent Office / Office européen des brevets**

(11) **EP 4 545 341 B1**

(12) **EUROPEAN PATENT SPECIFICATION**

(45) Date of publication and mention
of the grant of the patent:
**18.02.2026 Bulletin 2026/08**

(21) Application number: **23290038.1**

(22) Date of filing: **24.10.2023**

(51) International Patent Classification (IPC):
*B60L 3/12* (2006.01)     *B60L 53/80* (2019.01)
*B60L 58/12* (2019.01)     *B60L 58/14* (2019.01)
*B60L 58/16* (2019.01)     *B60L 58/18* (2019.01)
*G01R 31/367* (2019.01)     *G01R 31/392* (2019.01)
*H01M 10/48* (2006.01)     *H01M 10/54* (2006.01)
*H02J 7/00* (2026.01)

(52) Cooperative Patent Classification (CPC):
**B60L 58/16; B60L 3/12; B60L 53/80; B60L 58/12;
B60L 58/14; B60L 58/18; G01R 31/367;
G01R 31/392; H01M 10/48; H01M 10/482;
H01M 10/54; H02J 7/50; H02J 7/82; H02J 7/84;
B60L 2240/70;** (Cont.)

(54) **BATTERY OVERHAUL DEVICE**

**BATTERIEÜBERHAULUNGSVORRICHTUNG**

**DISPOSITIF DE REMISE EN ÉTAT DE BATTERIE**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**30.04.2025 Bulletin 2025/18**

(73) Proprietor: **Hitachi, Ltd.
Tokyo 100-8280 (JP)**

(72) Inventors:
• **LIN, Lan
06560 Valbonne (FR)**
• **GMUENDER, Anna
85445 Oberding-Schwaig (DE)**

(74) Representative: **MERH-IP Matias Erny Reichl
Hoffmann
Patentanwälte PartG mbB
Paul-Heyse-Straße 29
80336 München (DE)**

(56) References cited:
**US-A1- 2020 326 382     US-A1- 2021 081 875
US-A1- 2021 132 153     US-A1- 2023 011 148
US-A1- 2023 242 009**

(52) Cooperative Patent Classification (CPC): (Cont.)
     B60L 2240/80; B60L 2250/10; B60L 2250/12;
     B60L 2250/16

## Description

The present disclosure relates to a battery overhaul device, a corresponding method and computer program product.

## Background

Recent years have seen the introduction of a wide range of electric vehicles powered by storage batteries, such as HEVs (Hybrid Electric Vehicles), PEVs (Plug-in Electric Vehicles) and EVs (Electric Vehicles). Examples of storage batteries mentioned herein include a lithium-ion secondary battery and a nickel-hydrogen secondary battery. Electricity storage systems for supplementing electric power supply using storage batteries have been put into practical use in, for example, homes, buildings or factories. In such electric power storage systems, storage batteries are charged with surplus electric power generated or low-cost midnight electric power, while the storage batteries are used to supply electric power to electric appliances when the amount of electric power generation decreases or during a period when the cost of a commercial power source is high or when electric power is scarce.

Very severe conditions, such as repeated charging and high current output, are applied to a storage battery used to power a vehicle. Compared to these conditions, the conditions under which a storage battery used in a home energy storage system operates are moderate. Conventionally, a storage battery used in a vehicle can be technically recycled when it has deteriorated and can no longer meet the conditions of use. Specifically, the battery contains rare materials, so the deteriorated battery undergoes a decomposition process and is used as new battery materials.

However, even a storage battery that is unusable in a vehicle can often perform sufficiently well when used in other equipment, as a storage battery in a vehicle is subject to very severe conditions. In addition, the cost of recycling a storage battery is relatively high. For this reason, a problem arises in that the recycling of a storage battery that can be used for other equipment increases the total cost of the life cycle of a storage battery, from its manufacture to its recycling.

PTL1 (EP 3 026 751 B1) proposes a battery secondary use management system for managing the determination of a secondary use destination of a battery from a plurality of secondary use destination candidates by using information of the battery. It proposes a solution for mapping the predicted life time of a first-life battery application to the predicted replacement time of a possible second-life battery application. Then, this prior art document proposes a secondary use destination determination method to determine in advance the secondary use destination of the battery before the expiration of its first life use. The claimed objective of this prior art document is to reduce the lead time between first life and second life applications.

PTL2 (US 2020/326382 A1) discloses a secondary battery management device which is connected to electronic equipment using a secondary battery as a driving power supply via the Internet.

PTL 3 (US 2021/081875) discloses a remanufacturing support server which includes processor configured to acquire specification data representing required performance of a battery product.

PTL 4 (US 2023/242009) discloses a computing system which receives and compiles power cell data, and in certain examples, the power cell data can be distributed to a distributed ledger.

US 2023/011148 A1 discloses a battery overhaul device comprising a battery life span estimation unit configured to estimate the battery life span of the battery.

## Problem

However, in PTL1 possible overhaul actions such as remanufacturing, replacing and recycling of the batteries have not been considered. Moreover, in PTL1 a repurposing of a battery is only calculated within a specific time window i.e., when the battery use phase approaches its end but not along the entire use phase of a battery. In addition to that, PTL1 does not propose any solutions to the problem of abandoning still useful battery capacity or resources when a battery is transferred from a first use destination to a second use destination because it does not consider alternative battery overhaul actions such as remanufacturing or recycling.

In view of the above problem, it is an object of the subject-matter set forth in the appended claims to provide a solution for the implementation of a tool to optimize battery life cycles in order to facilitate a battery circular economy.

According to the present invention, the deterioration of a plurality of storage batteries which are relocated and used among a plurality of use destinations is predicted, and thus the determination of the optimal time for an overhaul of the battery and a possible relocation destination of the storage battery can be supported based on the result of the deterioration prediction. Accordingly, it is possible to contribute to comprehensive cost reduction, maximization of life span energy throughput and increased resource efficiency for the life cycle of a storage battery.

In particular, the present subject-matter proposes a modelling tool with optimization technology to select whether a battery may be replaced, remanufactured, and repurposed during its life time, by considering the state of health (SoH) of the battery, remaining salvage value as well as forecasted battery purchase cost. It also determines the optimal overall timing for replacing, remanufacturing and repurposing, in order that the overall life cycle cost of a battery-as-a-service model can be optimized not only with regard to monetary matters but also and most preferably with regard to the efficient use of resources and energy. For this purpose, the present idea may also take into consideration operation conditions of the possible secondary life applications which may influence the target optimization targets such as, forecasted battery replacement cost, the battery operating conditions which influence the battery and resource efficiency such as operation temperature, voltage etc.

The present subject-matter may furthermore be used in design phase and in an operation/planning phase. In the design phase, the proposed solution may estimate the overall product life cycle cost including possible circular economy operations to support investment decisions by, for example, comparing different investment plans for battery leasing services. In the planning phase, the solution may monitor the battery life cycle costs and revenue progress. In addition, by using the predicted battery health degradation and predicted life span, the proposed solution may estimate the possible life cycle cost of various battery overhaul options such as battery replacement, battery remanufacturing and battery repurposing. An optimization algorithm may then determine an optimal option and the corresponding timing for an overhaul operation. It also provides decision support for operation planning by considering battery life cycle cost and factors such as battery capacity and resources.

Detailed aspects and advantages of the present subject-matter will become apparent in view of the following descriptions and explanations. The invention is defined in the appended claims.

According to a first aspect of the subject-matter described herein, there is proposed a battery overhaul device for monitoring one or more batteries and determining battery overhaul actions for the one or more batteries from a plurality of possible battery overhaul action candidates by using information of the one or more batteries, comprising: a life cycle history determination unit configured to obtain life cycle history data including past overhaul actions of a battery of the one or more batteries; a battery state of health estimation unit configured to estimate a state of health of the battery; a battery degradation estimation unit configured to estimate a degradation of the battery state of health of the battery; a battery life span estimation unit configured to estimate the battery life span of the battery; a battery overhaul determination unit configured to select at least one battery overhaul action from the battery overhaul action candidates and to determine the timing of the selected battery overhaul action based on the estimated degradation of the battery state of health, the life cycle history data and the estimated battery life span; a notification unit configured to notify a user of the battery or a system in which the battery is mounted of the selected overhaul action and the determined timing, wherein, in predetermined planning cycles i: the life cycle history determination unit is configured to obtain updated life cycle history data including past overhaul actions of the battery;the battery state of health estimation unit is configured to estimate an updated state of health of the battery;the battery degradation estimation unit is configured to estimate an updated degradation of the battery state of health of the battery;the battery life span estimation unit is configured to estimate the updated battery life span of the battery;the battery overhaul determination unit is configured to newly select at least one battery overhaul action from the battery overhaul action candidates and to newly determine the timing of the newly selected battery overhaul action based on the estimated updated degradation of the battery state of health, the updated life cycle history data and the updated estimated battery life span; and the notification unit is configured to notify the user of the battery or the system in which the battery is mounted of the newly selected overhaul action and the updated determined timing.

A battery as described herein may be a rechargeable power storage device such as an accumulator to be provided in a system using electric power, comprising, for example, a lithium-ion secondary battery. The battery is provided by being packaged in a form of a battery pack which can be easily mounted on any system or equipment. Further, the battery pack comprises a plurality of battery modules bundled to provide a predetermined power and capacity. Further, each battery module has a plurality of battery cells mounted therein. The term information of the one or more batteries is preferably to be understood as data measured and monitored by a battery control unit and may for example be voltage, input and output currents, temperature, a state of charge (SoC), and a deterioration state (SoH: State Of Health) of a storage battery. The state of charge (SoC) is the ratio of the remaining capacity to the fully charged capacity. The state of health (SoH) is a value representing the state of deterioration of a storage battery, calculated from the internal resistance value of the storage battery.

Furthermore, the described battery overhaul device may in practice be provided with battery information comprising for example, a model number, a present use destination, the history of past use destinations, a minimum required capacity for the current application (which may be, for example. an initial capacity of a new battery and/or of a remanufactured battery), a voltage log, a current log, a temperature log, a state of charge (SoC), a state of health (SoH), and charge/discharge allowable electric power (also referred to as an state of power (SoP)). These information items are independently stored for all the registered storage batteries. Information on the voltage log, the current log, and the temperature log is stored as the series of data representing the voltage, current, and a temperature at a plurality of time points, respectively. Information on the state of charge, the state of health, and charge/discharge allowable electric power is also stored as the series of data representing the respective values at a plurality of time points.

Here, the charge/discharge allowable electric power (SoP) represents the maximum charge electric power and the maximum electric discharge electric power estimated from, for example, the voltage and the internal resistance of the storage battery.

According to the subject-matter described herein, a battery overhaul action may be an action involving a change in the status of the battery. Correspondingly, a battery overhaul action may be the remanufacturing, the replacement or repurposing of the battery or the disposal or recycling of the battery. Correspondingly, the term battery overhaul action candidate is preferably to be understood as one of the potential battery overhaul actions mentioned above which could potentially carried out with respect to a battery. The respective battery overhaul actions are discussed below in further detail.

The term life cycle of a battery is preferably to be understood as the time period that passes during and including the processes of engineering, designing and manufacturing as well as the servicing or overhauling until the recycling or disposal of a battery. Accordingly, in the life cycle of a battery different stages can be identified. Those stages comprise the extraction of raw materials, the production of the battery, the use phase and the end of life which may either be the disposal of the battery or the recycling of the raw materials involved in its production. All of the above main stages of the battery life cycle involve the input of energy and materials and the output of waste and emissions. Furthermore, the use phase can also be subdivided into additional stages in the battery life cycle. As a battery may be subjected to maintenance, remanufacturing or repurposing multiple times during its use phase, the time periods between those measures may also be considered as life cycle stages of the battery. The present subject-matter especially relates to those life cycle stages that are linked by battery overhaul actions during the use phase of the battery.

Correspondingly, the term life cycle history data relates to the life cycle stages/phases of a battery in the time period spanning from the first use of the battery to the disposal or recycling of the battery, i.e. it may also be considered as use mode data. For example, life cycle history data may comprise information on the use destination of a battery, information on how or if the battery has been maintained or remanufactured and information on the amount of time that has passed since the battery entered a new life cycle stage. In this regard, life cycle history data may also comprise information on the current and past use destinations of a battery. The first and second use destinations may also be referred to as first and second life of the battery respectively. In addition to that, the battery may be operated at more than two use destinations depending on the remaining battery state of health and the requirement profile of any additional use destination.

During its use phase a battery is subjected to the phenomenon of degradation. By completing charge and discharge cycles a battery will lose performance. The term degradation of the battery state of health describes this effect which is substantially affected by conditions under which the battery is used and the depth of discharge the battery undergoes. The depth of discharge is the amount of a batteries storage capacity which is used in a discharge cycle. The phenomenon of degradation may be quantified by the state of health of the one or more batteries and is a figure of merit of the condition of a battery (or a cell, or a battery pack), compared to its ideal conditions. The unit of the state of health is percent (100% = the battery's conditions match the battery's specifications).

Examples of degradation degree information of the battery include information of a current battery capacity (fully charged capacity) with respect to "a minimum required capacity for the current application" which may relate to an initial battery capacity of a new or/a remanufactured battery (fully charged capacity) (e.g. information of a rate of the current battery capacity when the initial battery capacity of a new/remanufactured battery is set to 100%) and the like. The information is managed by a controller, such as a battery controller, provided to facility on which the battery is mounted. In addition, although not particularly limited, examples of a method of obtaining degradation degree information of the battery may include using various communication technologies such as wireless communication and the like. Instead of the method using the communication technology, it is possible to use an aspect of obtaining the information through an electronic system diagnostic tester and the like.

According to the present subject-matter, the battery degradation estimation unit predicts the degradation progress of the battery based on the degradation degree information of the battery. Additionally, the battery degradation estimation unit may predict the time at which the battery reaches a predetermined degree of degradation based on use mode information, that is, the usage frequency of the battery or an amount of discharge in a predetermined period (for example, one week or one month). That is, for example, the battery degradation estimating unit stores in advance a degree of degradation progress (a capacity decrease rate) of the battery per unit number of days for each use frequency of the battery or each discharge in a predetermined period which may have been determined by an experiment or comparable activities of data collection.

The term battery life span is preferably to be understood as the total amount of time a battery can be operated in its use phase until its performance has deteriorated below a predetermined threshold. This threshold may be reached when the battery has only 20% of its minimum required capacity for the current application, i.e. the initial capacity of a new and/or remanufacture battery, to store energy left. A battery with a capacity that low is usually disposed of or its contents are recycled in order to regain resources for the production of new batteries or other products.

Another possible understanding of the term battery life span may be based on the relationship of time and the number of discharge/charge cycles of the battery, and, then, the overhaul time/timing can also be derived from or defined by a number of cycles.

The life span estimation unit may determine the life span by considering battery using the predetermined initial life span, i.e., product name plate life span, forecasted life span, and/or life span limited by overhaul operation. The forecasted life span may be calculated by using a predicted battery SoH evolution/degradation data as determined by the respective unit. E.g., the initial estimated life span of the first use stage may be simply given, e.g. by the manufacturer's product name plate or so, and any further use, e.g. the second and so forth application, may be forecasted by using data provided by the data storage unit or external sensors or data collection units connected to the battery overhaul device, said forecast data including one or more of forecasted leasing revenue, forecasted battery replacement cost, operation conditions of possible second life applications e.g. target life span, needed capacity, average operation temperature, and the like.

Preferably, the battery life span estimation unit includes the subfunction for providing the determined/estimated/calculated forecast data for the second, third and so on use stage in regard of the life span including the later described updating thereof.

The timing of a selected battery overhaul action is a point in time of the use phase of the battery which has been determined to be an optimal point in time to carry out a battery overhaul action in order to optimize the cashflow and cost when the battery is offered in the framework of a battery-as-a-service (BaaS) model. Furthermore, preferably the optimal point in time to carry out a battery overhaul action may be a point in time which has been determined to be an optimal point in time to carry out a battery overhaul action in order to optimize the battery life span energy throughput of a battery. Also, preferably the optimal point in time to carry out a battery overhaul action may be a point in time which has been determined to be an optimal point in time to carry out a battery overhaul action in order to optimize the material efficiency with regard to material input and output during the use phase of the battery. Instead of the above described with the term point in time, as noted as an alternative understanding above, the number of cycles may be used.

The notification unit may be a conventional display unit with a graphical user interface which is configured to display information or processed information to the user of the battery. Moreover, the notification unit may comprise one or more user input/output (I/O) components. For example, the notification unit may include a touch screen display, operable to present information and a graphical user interface (GUI) to a user of the battery and to receive indications of user selections. The user notification unit may include a keyboard or keypad, and/or a cursor controller (e.g., mouse, trackball, trackpad) to allow a user of the battery to enter information and/or select user selectable icons in a GUI. The notification unit may include a speaker to provide aural messages to a user of the battery and/or a microphone to receive spoken user input such as spoken commands.

The user of the battery may be a person that drives an electric vehicle on which the battery is mounted or a facility manager that tends to a building or a factory which is equipped with the battery as a secondary energy source.

The system on which the battery is mounted may be an electric vehicle which is equipped with an automated controller that manages the status and operation of the battery. The system on which the battery is mounted may also be a building or factory which is equipped with an automated controller that manages the status and the operation of the battery.

The battery overhaul device may be implemented as a computer including, for example, a CPU (Central Processing Unit) as an arithmetic unit, a RAM (Random Access Memory) and a hard disk as storing section, a communication apparatus, a display or a printer as an information output section, and an input apparatus for inputting an operational command from an operator.

Also, the battery overhaul device may be implemented as a centralized server which collects information on a plurality of batteries representing a state of a plurality of batteries used in a plurality of vehicles, a plurality of houses, a plurality of buildings, and a plurality of factories, and stores the information in a data storage section. The battery information is collected always or periodically. Said server is capable of exchanging data with the communication sections of the plurality of vehicles, the plurality of houses, the plurality of buildings, and the plurality of factories through a communication apparatus connected to a network. Accordingly, on the basis of this information regarding battery overhaul action and its timing a user of the battery, an automated system operating the battery or an operator or worker can be provided with an optimized battery overhaul schedule comprising for example an optimized timing for relocation, remanufacturing or repurposing of one or more batteries. This effectively contributes to a comprehensive cost reduction for the life cycle stages of one or more batteries reaching from manufacturing to recycling or disposal of the one or more batteries.

Summarizing, the above-described battery overhaul device is able to determine a combination of an optimal battery overhaul action and the optimal timing to conduct said battery overhaul action on the basis of an estimation of the degradation of the state of health of a battery, an estimated life span of said battery and/or life cycle history of said battery. After that a user of the battery or a system in which the battery is mounted is notified of the selected battery overhaul action and the determined optimal timing to conduct said battery overhaul action.

The above-described subject-matter offers the technical advantage of an increase of the battery life span energy throughput. The above-described subject-matter furthermore offers the possibility to optimize the determination of the best battery overhaul options/candidates and their timing to maximize the overall energy delivery and energy consumption through the overall life span of the one or more batteries.

In order to realize the optimization, a key performance index (KPI) relating to the total amount of energy throughput capacity may be used. Moreover, a KPI relating to the material efficiency, which measures the inflow and outflow of material in order to maintaining the battery operational life during its use phase may be used. In addition to that, it may also be possible to use a KPI for the previously described optimization which relates to the net present revenue of the one or more batteries. The calculation of the respective KPIs is discussed further below.

In addition to an increase of the battery life span energy throughput, the resource consumption of the operation and maintenance of the one or more batteries can be reduced because of the selection of an optimal battery overhaul action at an optimal point in time. In other words, the amount of resources necessary to conduct a battery overhaul action can be minimized by the selection of an optimal battery overhaul candidate at an optimal point in time. This way unnecessary battery overhaul actions can be avoided when a battery is still performing well. On the other hand, a battery that has a deteriorated performance and should otherwise be replaced, can be subjected to a battery overhaul action before any further deterioration of performance would make a resource intense replacement expedient. In even other words, the claimed subject-matter offers the advantage of an optimized material in and outflow while optimal performance of the one or more batteries is ensured.

Apart from the benefits of increased battery life span energy throughput and the more resource efficient use phase that can be achieved by the present subject-matter, an increase in the time a battery can be operated until it has to be recycled or disposed of can be achieved. Moreover, in a case in which the one or more batteries should be operated within in the framework of a battery as a service model, a substantial reduction of the cost related to operation and maintenance can be achieved.

Also, the optimization of the overall use time of the one or more batteries offers the possibility to reduce the stock of spare batteries because of more efficient use of the existing fleet of batteries. This leads to cost reduction lower resource consumption. In other words, less new batteries are necessary to provide maintain the overall amount of energy that can be provided by the one or more batteries. This leads to a decrease of the extraction of raw materials which results in ecologic benefits.

Furthermore, due to the selection of an optimal battery overhaul action the periods in which a battery cannot be used can be reduced because maintenance and downtimes can be decreased to a minimum. This especially concerns still well performing battery modules that do not require maintenance or repair.

More advantages of the present subject-matter will become obvious in the in view of the additional preferred aspects discussed below.

According to a preferred aspect of the subject-matter disclosed herein, the candidates for battery overhaul action may be predetermined and may comprise no battery overhaul action, remanufacturing, replacement or repurposing of the battery. Preferably, the candidates for battery overhaul actions may be predetermined by a set of candidates for secondary use application and such set preferably may include one or more of the above listed battery overhaul actions.

Further it is noted that preferably the battery overhaul determination unit may be configured to skip the calculation of a timing when "no overhaul action" has been selected as the next action. More preferably, the timing determination is skipped if no overhaul action is selected and the battery is still in its first use phase.

Remanufacturing of a battery may comprise the rebuilding the battery to specifications of the original manufactured product using a combination of reused, repaired and new parts. It aims at the recovery of a whole product and the prolonging of its useful lifetime with minimal additional cost. An additional outcome of the remanufacturing process is its limited environmental impact, because of the limited input of new materials and process energy compared to the manufacturing of a new product. Accordingly, most of the components of the remanufactured product come from the original product and comparatively little energy needs to be used for their inspection, preparation and reuse.

As batteries for electric vehicles may be repurposed during their use phase to power residential homes, factories or to be introduced into energy storage facilities a remanufacturing may be a viable option to extend the battery life span during the life cycle stages and substages of a battery.

When the performance of a battery drops below a certain state of health, the battery has reached the end of its use-phase and needs to be replaced by a new battery. Therefore, the term replacement is preferably to be understood as a battery overhaul action in which a battery has reached the end of its use phase and needs to be replaced by another battery that is able to fulfil the requirements of the use destination of the battery that needs replacement. The battery may be replaced by a used battery which was repurposed from another use destination or a completely new battery.

The term repurposing of a battery is preferably to be understood as the removal of a battery which does not fulfil the requirements of a first use destination and subsequent introduction into a second use destination with lower requirements. This may for example include car batteries that have decreased capacity due to a state of health degradation that are repurposed to be energy storages for stationary facilities such as residential buildings, stand-alone power systems or backup power systems for industrial applications. Said use destinations are only examples for a diverse set of possible use destinations and are not to be regarded as comprehensive.

By using the options of remanufacturing, repurposing and replacement as battery overhaul action candidates, the degradation of the state of health of one or more batteries can be slowed down and the use phase of the one or more batteries can be extended. More specifically, if the repurposing has been selected as the optimal battery overhaul action, the battery can be assigned to a use destination which has less severe conditions under which the battery has to function.

This means, that a batter which may not have the capacity or performance any more to power an electric vehicle may be repurposed to a use destination with less demanding environmental conditions and less intense charge/discharge cycles.

This also results in a reduced waste of battery performance since batteries which have undergone a significant degradation can be assigned to a use destination/application which is best suited to make the most of its remaining capacity. This also applies to battery performance as well. A battery which may have undergone a significant degradation of its peak electricity output may be assigned to a use destination which may put less stress on the battery wherein further battery degradation can be slowed down.

Moreover, by including remanufacturing as a battery overhaul action candidate, a battery that has a state of health which may have dropped below the requirements of its current use destination can be remanufactured to once again be a suitable to be used as an energy storage for said use destination. It is noted that the process of remanufacturing is especially beneficial with regard to providing a resource efficient course of action in order to maintain the functionality of a battery once it hast been selected to be the optimal battery overhaul action by the battery overhaul device.

Correspondingly, if repurposing has been selected as the optimal battery overhaul action by the battery overhaul device, an especially beneficial way of extending the use phase of a battery with regard to resource efficiency and battery energy throughput capacity can be implemented. In other words, the repurposing of a battery does not involve the input of additional resources and enables the use of a battery in a second use destination that would otherwise have to be fitted with a new battery. As a result, the energy throughput capacity of a battery is not wasted and neither energy nor resources have to be used in order to produce a new battery.

If replacement of the battery has been selected as the optimal battery overhaul action candidate, the battery may not be in a condition to be used as an energy storage but it can be stripped for parts and resources which can be reintroduced to the production cycle in order to produce new batteries.

According to the invention, the life cycle history determination unit may be configured to obtain updated life cycle history data including past overhaul actions of the battery. Furthermore, the battery state of health estimation unit is configured to estimate an updated state of health of the battery.

Also, the battery degradation estimation unit **is** configured to estimate an updated degradation of the battery state of health of the battery. Moreover, the battery life span estimation unit **is** configured to estimate the updated battery life span of the battery; the battery overhaul determination unit **is** configured to newly select at least one battery overhaul action from the battery overhaul action candidates and to newly determine the timing of the newly selected battery overhaul action based on the estimated updated degradation of the battery state of health, the updated life cycle history data and the updated estimated battery life span. In addition to that, the notification unit is configured to notify the user of the battery or the system in which the battery is mounted of the newly selected overhaul action and the updated determined timing. All of the above are carried out, in predetermined planning cycles.

With regard to the present subject-matter the term planning cycle is preferably to be understood as a time period which may be expedient to conduct an update of the state of health of a battery as well as the degradation of the batter state of health, battery life span and the predicted battery life span of the battery. This time period may be set arbitrarily in order to represent an expected significant change of the above parameters during a certain period of time. Also, an interval or planning cycle may be determined based on experimental findings in order to establish a suitable time period for updating the above parameters. This way, an interval or planning cycle can be set to optimally correspond to changes which are significant enough to change the outcome of the selection of a battery overhaul action and its timing and to avoid unnecessary iterations of their selection and determination. Accordingly, processing capacities can be saved and the process of determining an optimal battery overhaul action and its timing can be conducted in a more efficient manner with regard to computational effort.

With regard to the present subject matter an interval may be denoted by the letter i. An update interval i may most preferably be chosen in such a way that an update may be conducted at least one time during each single life cycle stage of the one or more batteries. With every update i may correspondingly be increased by one at a time (such as $i+1$, $i+2$ and so on).

With regard to the present subject-matter updated life cycle history data, an updated state of health, an updated degradation of battery state of health, and an updated battery life span refers to the result of a periodically conducted determination or estimation of the above parameters in order to provide an up-to-date basis for a reliable selection of a battery overhaul action and the necessary determination for the timing of the selected battery overhaul action.

As a battery starts its use life as a brand-new device, the first values of the above-mentioned parameters might be pre-set, entered by the user or determined during the first commissioning of the battery. Afterwards (i.e., after the first update) the respective values will be replaced with the updated values.

The updating of the above-mentioned parameters in predetermined planning cycles/intervals offers the advantage of being able to adapt the selection of a battery overhaul action and the determination of its timing to the changing circumstances under which a battery may be operated and to compensate for changes which may lead to a suboptimal output of the optimization process carried out by the battery overhaul device.

Correspondingly, notifying the user or the system on which the battery is mounted of a newly selected overhaul action and an updated determined timing of the battery overhaul action holds the advantage that the user can appropriately grasp the time to carry out a battery overhaul action and thus it is possible to allow the user to appropriately prepare for actions such as repurposing, replacement or remanufacturing. In addition, when the use phase of a battery is approaching its end or the end of the use phase is already reached, the battery overhaul device may give the user a warning indicating that replacement of the on-board battery is necessary. According to this, it is possible to encourage the user to collect the on-board battery, and thus it is possible to improve accuracy of collecting the battery. This is especially beneficial when the battery should be an onboard battery of an electric vehicle.

Moreover, updating of the above-mentioned parameters during the active use of one or more batterie in use is favourable in view of being able to implement an always up-to-data overhaul regime. In other words, by periodically updating the input to the optimization process a maximization of possibly energy throughput, resource efficiency and cost efficiency of one or more batteries can be achieved.

According to another preferred aspect of the subject-matter disclosed herein, the notification unit may further be configured to request confirmation from the notified user or the system on which the battery is mounted if the selected overhaul action is no overhaul action.

Requesting the user or the system on which the battery is mounted after a notification that the selected battery overhaul action is no overhaul action to confirm the selection result of the battery overhaul device offers the advantage of providing the user or the system on which the battery is mounted with up-to-date information with respect to the overall state of the battery. By confirming the notification that the selected overhaul action is no overhaul action the user or system on which the battery is mounted acknowledges that the battery is in a condition fit for further operation at its current use destination. This enables the user or the system on which the battery is mounted for better planning on their side with respect to the further use of the battery in the time period until a battery overhaul action is newly selected as described above.

According to another preferred aspect of the subject-matter disclosed herein, if the selected overhaul action is another overhaul action than no overhaul action, the notified user or system on which the battery is mounted may be prompted to confirm execution of the selected overhaul action. Furthermore, if the selected overhaul action is replacement, the battery overhaul device may be configured to terminate the monitoring of the battery. Moreover, if the selected overhaul action is neither no overhaul action nor replacement, the battery overhaul device may be configured to update the life cycle history data of the battery.

Prompting the user or the system on which the battery is mounted to confirm the selected battery overhaul action if the selected battery overhaul action is another overhaul action than no overhaul action to confirm the execution of the selected overhaul action is especially beneficial in view of the implementation of a guided interaction between the user/system and the battery overhaul device. In other words, this leads to the above-described advantages with regard to reduced operation and maintenance cost of one or more batteries and increased resource efficiency as well as the improved capacity for total energy throughput while also leaving the final decision regarding the execution of the battery overhaul action to the user or system on which the battery is mounted.

Furthermore, by terminating the monitoring of the one or more batteries, if the selected battery overhaul action is replacement, the monitoring of the one or more batteries can be further optimized because a battery that is no longer relevant for the selection of a battery overhaul action is removed from the selection process. This reduces computational effort and reduces the complexity of the optimization process if there should be more than one battery.

Moreover, by updating the life cycle history data of the battery if the selected battery overhaul action is neither no battery overhaul action nor replacement, the above described-advantages of adapting the selection of an optimal battery overhaul action and the determination of its timing to the current use and the current use destination can be achieved. In doing so, the life cycle history data can be kept up-to-data with every planning cycle/interval what results in a more reliable selection of the battery overhaul action that should be performed.

According to another preferred aspect of the subject-matter disclosed herein, the battery overhaul determination unit may be configured to select a battery overhaul action candidate corresponding to the material inflow which is needed to carry out the battery overhaul action.

With respect to the present subject-matter the term material inflow is preferably to be understood as any type of material or component that is needed in order to perform a battery overhaul action. For example, the remanufacturing of a battery may necessitate the swapping of battery modules or peripheral devices which represent the introduction of additional materials and devices to a battery compared to its initial factory setting. The amount of material inflow may vary with the extent of remanufacturing that has to be carried out and the battery type. The material outflow on the other hand relates to the amount of materials and devices which are removed from the battery during a battery overhaul action. With regard to the example of remanufacturing, material outflow may be damaged or deteriorated battery modules or peripheral devices that have to be replaced in order to restore the capacity of the battery.

By selecting a battery overhaul action on the basis of the material or resource consumption that is caused by said battery overhaul action, a more resource efficient way to operate a battery can be achieved. More specifically, by selecting a battery overhaul action that involves as little material inflow as possible or the least of the different options, the use phase of one or more batteries can be extended in the most resource efficient way possible. As a result, resource consumption of the operation and maintenance of one or more batteries can be minimized by the battery overhaul device.

According to another preferred aspect of the subject-matter disclosed herein, the battery overhaul determination unit may be configured to select a battery overhaul action candidate corresponding to the change of the state of health of the battery caused by carrying out the battery overhaul action, e.g. a selection based on the optimal/comparably best (e.g. largest increase) change of the state of health.

With respect to the present subject-matter the term change of the state of health of a battery is preferably to be understood as the increase of the capacity or state of health of a battery that is caused by carrying out a battery overhaul action. On the other hand, under certain circumstances carrying out an overhaul action may also have detrimental effects on the state of health of a battery.

By selecting a battery overhaul action on the basis of the change of the state of health of the one or more batteries, the overall capacity of energy throughput can be increased and accordingly an optimal overhaul action leading to the most efficient way to utilize battery capacity can be selected. As a result, the possible waste of storing capacity when a battery overhaul action is carried out can be minimized by the battery overhaul device.

According to another preferred aspect of the subject-matter disclosed herein, the battery overhaul determination unit may be configured to select a battery overhaul action candidate corresponding to the life cycle cost of the one or more batteries.

With respect to the present subject-matter the term life cycle cost of a battery is preferably to be understood as the total cost of a battery over its complete life cycle including initial capital costs, maintenance costs, operating costs and the residual value of battery at the end of its life. Most preferably the life cycle cost is quantified by the net present value of the battery which is the difference between the present value of cash inflows and cash outflows over a predetermined period of time. Herein, this period of time may be the time span of a complete battery life cycle or a time span or sum of time spans of respective life cycle stages of a battery.

By selecting a battery overhaul action on the basis of the best (e.g. lowest) or most preferable life cycle cost of the one or more batteries, an improved life cycle management simulator or a monitoring solution for one or more batteries can be implemented. In the case of a battery-as-a-service model for the provision of electrical storage, the owner of a battery park which leases the batteries to be operated in different applications, the described battery overhaul device is able to monitor the battery health status in real time or predetermined intervals in order to ensure reliable energy storage. In addition, the present subject-matter provides a useful tool in making planning decisions which not only depend on the current health status of a battery, but also the estimated costs and revenues by including the potential of use of a repurposed battery.

According to another preferred aspect of the subject-matter disclosed herein, the battery overhaul determination unit may be configured to select a battery overhaul action candidate corresponding to the life span energy throughput of the one or more batteries.

With respect to the present subject-matter the term life span energy throughput of a battery is preferably to be understood as the sum of all the electric power a battery can output during its entire use phase. As will be known to those skilled in the art the life span energy throughput of a battery is subjected to a variety of parameters such as the environmental conditions under which a battery is operated, the charge and discharge currents of the battery and the state of charge range a battery covers during its charge/discharge cycles.

By selecting a battery overhaul action on the basis of life span energy throughput of the one or more batteries, e.g. based on the highest life span energy throughput achievable of the different options, the capacity of each battery can be used in an optimal way without squandering the potential for energy storage. In doing so a more energy efficient way to use a battery can be implement and therefore the available storage capacity provided by one or more batteries can be used to an increased extend without abandoning unused capacity and raw materials.

It is noted that the above exemplary selection options can also be combined so that all of the different options are combined or some of them, e.g. a combination of the sections options may foresee that the selection is performed based on material inflow and life span energy throughput, to mention one of various possible combinations of the above options.

According to another preferred aspect of the subject-matter disclosed herein, the battery overhaul determination unit may be configured to determine the timing to perform a battery overhaul action based on the estimated degradation of the battery state of health and a use mode of the battery.

As it is generally known, a battery deteriorates and a gradual decrease of the discharge capacity (also referred to as battery capacity) takes place by repeating charge and discharge. The magnitude of a charge/discharge current for the storage battery, i.e., the severity of use of the storage battery also varies the rate of deteriorating the storage battery. For example, a higher charge/discharge current increases the rate of the deterioration, and a lower charge/discharge current decreases the rate of the deterioration.

For example, if the battery is used to power an electric vehicle, the battery outputs a large current in the case of running, and rapidly charges in the case of charging. Therefore, the use conditions for the battery in a vehicle are very severe in comparison with other facilities. Moreover, since an electric vehicle is required to have a high storage battery performance, the storage battery performance reaches the lower limit of the required performance of an electric vehicle at a stage at which the deterioration degree of the storage battery does not progress so much.

On the other hand, the battery may be used to provide electricity for a house/residential building. In this use destination the battery charges and discharges relatively moderately. Furthermore, in a house or building, the installation space for a battery is large in comparison with an electric vehicle, and many storage batteries can be used in parallel. Therefore, in a house or building, the use conditions of the battery are moderate in comparison with an electric vehicle. Moreover, since the use conditions are moderate, the storage battery performance required for a house or building is low in comparison with that for an electric vehicle.

Moreover, there may also be an example case when the battery is used in a factory. In a factory, the battery charges and discharges in a further planned and stable manner. Moreover, in a factory, the installation space for a battery is large in comparison with a house or building, and a large number of storage batteries can be used in parallel. Therefore, the use conditions for a battery in a factory are moderate in comparison with the use conditions for a house or building. Moreover, since the use conditions are moderate, the storage battery performance required for a factory is low in comparison with those for a house or building or an electric vehicle.

Therefore, the progression degree of deterioration is large in a battery used in vehicle, and decreases in the storage batteries used in a house or building and factory in this order. Moreover, even if the electric vehicles are of the same type, respective vehicles involve different progression degrees of deterioration since, for example, users use vehicles at different frequencies and have different driving styles. In the other facilities, the progression degrees of deterioration also differ in the respective facilities similarly.

Accordingly, as the use mode may be decisive for the degradation of the capacity of the battery, the determination of a timing to perform a battery overhaul action based on the estimated degradation of the battery state of health and the use mode of the battery is especially beneficial for the accurate and reliable determination of said timing. Therefore, the battery overhaul device is capable of adapting the determination of the timing to conduct a battery overhaul action in the respective cases of different use modes and to additionally consider the use mode for the timing determination. The result of the above-described determination can hence enable the determination of an optimal time to carry out a battery overhaul action for one or more batteries.

According to another preferred aspect of the subject-matter disclosed herein, the battery degradation estimation unit may be configured to estimate a time at which a battery capacity of the battery reaches a first predetermined value of a minimum required capacity for the current application, which may be the initial battery capacity of a new and/or remanufactured battery, on the basis of the estimated degradation of the state of health of the battery. Additionally, the battery overhaul determination unit may be configured to determine the timing to carry out a battery overhaul action when said capacity is or will be reached.

In other words, the battery overhaul device is configured to predict the end of a life cycle stage of one or more batteries on the basis of the time at which the state of health of the battery reaches a predetermined degree of degradation. The end a of a life cycle stage of the one or more batteries may be set to the time at which a capacity reaches 80% of the minimum required capacity for the current application, e.g. including of the initial capacity of a new/remanufactured battery. Alternatively, information of a travel distance for each travel may be searched from use mode information of an electric vehicle on which the battery is mounted, and the end of the life cycle stage may be predicted on the basis of the searched information.

Specifically, the above-mentioned use mode information may indicate whether the vehicle on which the battery is mounted is mainly used for long-distance transportation or is mainly used for short-distance transportation on the basis of travel distance information for each travel. In addition, when the vehicle on which the battery is mounted is mainly used for long-distance transportation, for example, the end of a life cycle stage of the battery is set to time at which a capacity reaches 85% of the minimum required capacity for the current application, e.g. the initial capacity of a new/remanufactured battery (time at which the degradation degree is relatively low). On the other hand, when the vehicle on which the battery is mounted is mainly used for short-distance transportation, for example, the end of a life cycle stage of the battery is set to time at which a capacity reaches 80% of the minimum required capacity for the current application, e.g. the initial capacity of a new/remanufactured battery (time at which the degradation degree is relatively high). In addition, when the end of a life cycle stage of the on-board battery is determined in advance for a lease contract of the on-board battery, car sharing, and the like, the expired use time is set to expired use time which is determined in advance.

By determining the timing to carry out a battery overhaul action when a certain capacity of the one or more batteries is reached, it can be ensured that a battery is able to fulfil the requirements of the use destination at which it is used. Correspondingly, the battery overhaul action may be selected to be repurposing of the battery when it reaches first predetermined value of remaining battery capacity. For example, a battery which is mounted on an electric vehicle as a main power source may not be suitable for further use when its capacity drops to a value which lies below 80% of its minimum required capacity for the current application, e.g. the initial capacity of a new/remanufactured battery. However, the same battery may be a good fit to power a residential building or factory because the requirements to power output and the charging regime are not as severe as when operated in an electrical vehicle.

It should be noted that the value of 80% above is a preferred example which can be changed depending on other requirements, preferences or the like, e.g. to be set to 70%, 75%, 85%, 90% or the like.

The timing estimation/determination in general, as stated above may include all or at least one of the estimated degradation of the state of health, life cycle history data and the estimated battery life span or the updated data thereof. The above example in regard of setting a certain capacity of the one or more battery to be reached may use all of the above mentioned data, because the overall life span estimation and the estimated degradation data may be used for predicting a past and/or future life time state of health curve of the one or more batteries based on which it may be projected/predicted when a first threshold (first predetermined value of remaining battery capacity) will be reached and the life cycle history data, including e.g. a use mode, may provide information as to the first use stage which may, e.g., have an influence on the optimal timing of the second use stage. According to another preferred aspect of the subject-matter disclosed herein, when the capacity reaches a first predetermined value of a minimum required capacity for the current application, which may, e.g., be the initial capacity of a new/remanufactured battery, the battery overhaul determination unit may be configured to select the battery overhaul action to be remanufacturing, replacement or repurposing of the battery.

As has been explained above, if the current capacity of a battery is estimated to have reached for example 80% of its initial value, it may not be suitable to be used at its current use destination any more. It is therefore beneficial, to carry out a battery overhaul action that either restores part of the batteries lost capacity or to remove it from its current use destination in order to replace it with a new battery or a used battery with higher capacity. By either restoring the capacity of the battery or transferring it to another use destination, resource efficient way to maintain battery capacity or to still make use of remaining battery capacity respectively can be implemented according to the present subject-matter. Moreover, by extending the use phase of a battery overall resource consumption can be lowered and costs of operation and maintenance can be lowered.

According to another preferred aspect of the subject-matter disclosed herein, the battery degradation estimation unit may be configured to estimate a time at which a battery capacity of the battery will reach a second predetermined value of a minimum required capacity for the current application, which may, e.g., be the initial capacity of a new/remanufactured battery, on the basis of the estimated degradation of the state of health of the battery. Additionally, the battery overhaul determination unit is configured to determine the timing to carry out a battery overhaul action when said capacity is reached.

In other words, the battery overhaul device is configured to predict the end of a life cycle stage of one or more batteries on the basis of the time at which the state of health of the battery reaches a second predetermined degree of degradation. The end a of a life cycle stage of the one or more batteries may be set to the time at which a capacity reaches 20% of the initial capacity.

Because a remaining capacity of 20% is value at which its generally acknowledged that a battery has reached the end of its use phase it marks a favourable point in time to perform a battery overhaul action. As it is explained below, preferably expedient battery overhaul actions at that point would be replacing or recycling of the battery.

According to another preferred aspect of the subject-matter disclosed herein, when the capacity in use reaches a second predetermined value of a minimum required capacity for the current application, which may, e.g., be the initial capacity of a new/remanufactured battery, the battery overhaul determination unit may be configured to select the battery overhaul action to be replacement and/or recycling of the battery.

As described above, a beneficial course of action when a battery reaches a remaining capacity of 20% of its initial capacity in the new or remanufactured state is to replace the battery with a new battery and discard the old one or in a more favourable alternative to recycle the battery in order to regain resources which can be used in the manufacturing of new batteries.

By selecting the battery overhaul action to be replacement or recycling of the battery when the battery has reached a remaining capacity of 20% it can be ensured that the battery is extensively used until it has reached the end of its use phase. Hence, a battery can be used in a very resource efficient manner until the raw materials which were used to build it can be returned to the production phase as secondary raw materials. Furthermore, because the battery is used to provide electricity until the very end of its use phase, no storage capacity is wasted and a cost-effective use of said storage capacity can be implemented.

According to another preferred aspect of the subject-matter disclosed herein, the battery overhaul action of replacement may comprise moving the battery from a first use destination to a second use destination.

As described above, a use destination of a battery may be any facility in which a battery can be mounted in order to store and provide electricity. Most preferably, a first use destination may an electric vehicle and a second use destination may be a house/residential building or a factory. Other configurations may also be conceivable such as an electric vehicle being the first and second use destination. Furthermore, there may also be a third and fourth use destination and so on where for example a battery is transferred from a use destination with comparably high performance requirements along a succession of use destination with decreasingly lower performance requirements.

According to another preferred aspect of the subject-matter disclosed herein, the battery overhaul determination unit may be configured to determine whether or not the battery has a state of health determined to be suitable for on-board use based on the estimated degradation of a battery state of health, and to set the second use destination of the battery to a vehicle when the battery is determined be suitable for on-board use.

In other words, according to the previously discussed aspects of the present subject-matter, the secondary use destination of a battery that is used as an on-board battery which is currently mounted on a vehicle is selected from the plurality of stationary facilities, and the selected stationary facility is determined as the secondary use destination of the on-board battery. However, according to this aspect of the present subject-matter, when repurposing the on-board battery which is currently mounted on the vehicle, it is determined whether or not the on-board battery can be used in another vehicle. When the on-board battery can be used in another vehicle, the on-board battery is secondarily used in another vehicle.

More specifically, the battery overhaul device determines whether or not the battery lifespan and the output performance for example in the form of the battery state of health are equal to or greater than a predetermined threshold. When the battery lifespan and the output performance are equal to or greater than the predetermined threshold, it is determined that the on-board battery can be secondarily used for the on-board use and the battery may be transferred to another electric vehicle. On the other hand, when the battery lifespan and the output performance is less than the predetermined threshold, it is determined that the on-board battery cannot be secondarily used for the on-board use, and the battery may be repurposed to a second use destination which is a stationary facility such as a house or a factory. Further, in this case, for example, the predetermined threshold is set to a value for determining whether or not the battery lifespan and the output performance are equal to or greater than a level demanded for the on-board use. As described above, the threshold may be set to 85% or 80% of the initial capacity of the battery, wherein the initial capacity may be measured based on the new or remanufactured state of said battery.

Furthermore, in a further preferred a combination of a timing and a combination of use cases/applications/destinations may be optimized in one process flow. In other words, the selection of battery overhaul action candidates for the entire life span of the one or more batteries and the timing of each selection action can be optimized in a combined/merged determination process. For this purpose, a KPI can be used which value is optimized for different possible combinations and the combination with the best or most suitable or user-selected KPI value is then performed/followed/monitored by the battery overhaul device as proposed herein. For example, a KPI, as explained above, may be the overall life span costs wherein the term costs may not necessarily be equated with monetary value but it may also be simply be considered as a technical variable to be optimized, where the optimization is performed by the battery overhaul device as proposed herein, preferably performed by a dedicated KPI optimization unit of the battery overhaul device, and/or by the system proposed herein which may further include the data storage device and the data interfaces for data collection.

For example, preferably, the battery overhaul device may be configured to include the battery overhaul determination unit which selects an overhaul action and determines the timing of a selected overhaul action by using a KPI optimization unit which may be part of the battery overhaul device. Said KPI optimization unit may perform an optimization process for a key performance factor, including overall life cost, overall benefits (e.g., definable by user), overall energy throughput, or overall material flow, in view of a plurality of combinations of an overhaul action and the timing thereof. The KPI optimization unit may further returns to the battery overhaul determination unit for each battery of the one or more batteries one or more battery overhaul actions to be selected during the estimated life span of said battery and the timing of each selected battery overhaul action which return the optimal KPI value. In other words, a combination of overhaul actions (one or more during a life span of said battery) and the/their timing(s) might be returned to the battery overhaul determination unit. The term "optimal" shall be understood in dependence on the KPI, e.g., if the KPI is related to overall costs or overall material inflow or the like, optimal shall mean the combination with the minimum KPI value is returned or at least the combination with a local minimum KPI value. Further, optimal may also mean that the user is prompted to select a combination by displaying a range of different combinations and their KPI values to them and the user's choice is considered as the "optimal". Otherwise, if the KPI relates to energy throughput or the like, naturally, the optimal shall indicate the maximum or local maximum or the user's choice as described above.

For example, preferably, a battery has two use stages/destinations over the life span which means that one overhaul action with one timing associated therewith must be found and the KPI optimization unit optimizes different overhaul actions, i.e. combinations of two different use stages, with different timing. However, of course, the process may also be performed with more than one overhaul action during the battery's life span.

The KPI optimization unit provides the technical benefit that the optimal combination of overhaul action and the related timing for a battery can be determined. The optimization process is preferably updated during each period i so that the selected battery overhaul action and/or the timing thereof may change during the use of the battery (of course only as long as it has not been performed already) and during each update processing/period so that it is ensured that the optimal handling of the battery is provided over the entire life time.

Also, there is proposed a method for monitoring one or more batteries and determining battery overhaul actions for the one or more batteries from a plurality of possible battery overhaul action candidates by using information of the one or more batteries, comprising the steps to obtain life cycle history data including past overhaul actions of a battery of the one or more batteries; estimate a state of health of the battery; estimate a degradation of the battery state of health of the battery; estimate the battery life span of the battery; select at least one battery overhaul action from the battery overhaul action candidates and determine the timing of the selected battery overhaul action based on the estimated degradation of the battery state of health, the life cycle history data and the estimated battery life span; and notify a user of the battery or a system in which the battery is mounted of the selected overhaul action and the determined timing.

Moreover, a computer program product is proposed which is configured to carry out the above-described method.

In the following the claimed subject matter will be further explained based on at least one preferential example with reference to the attached drawings, wherein:

Figure 1     shows a schematic depiction of the general concept of the present subject-matter

Figure 2     shows a schematic overview of the battery overhaul device and a data storage unit

Figure 3     shows an example of a general calculation flow of the overhaul determination process

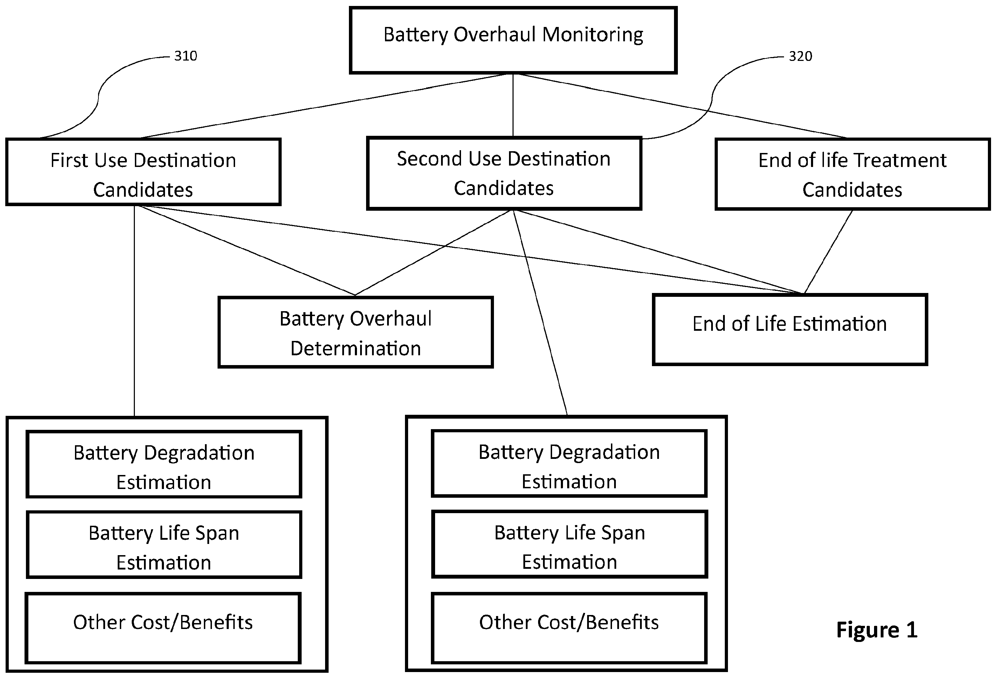

Figure 1 is a schematic depiction of a general concept of the present subject-matter. The battery overhaul device 100 is responsible for selecting the most appropriate option of overhaul (e.g., replacement, remanufacturing, or repurposing or not to overhaul) and determine its timing. The calculation may be realized to optimize a predefined KPI, such as maximizing the battery energy throughput, optimizing resource inflow and outflow or minimizing the battery operational costs through its use phase. In one of the possible implementations of the present subject-matter, a KPI may be the maximization of the annualized cash flow of a target business model. A battery overhaul action to be carried out is then selected based on a combination of:

1) a possible first life battery application or use destination 310 (e.g., based on the type of battery, configuration of the battery product, operation profile of the battery, expected energy consumption pattern of the battery),

2) zero, one, or more than one possible second life battery applications or use destinations 320 (e.g., based on type of battery, configuration of the battery product, operation profile of the battery, expected energy consumption pattern of the battery),

3) a possible battery end of life treatment of the battery, either taken from a first life application or first use destination 310 or a second life application or second use destination 320.

For each one of the first life and second life application candidates, the possible life cycle cost and benefits are calculated. Said calculation at least includes one or more of:

1) Battery degradation and its related costs along the battery life cycle (or battery salvage value) by considering a battery initial purchase cost, a battery initial state of health when new or remanufactured, a battery purchase cost at the time of calculation, and a battery health status at the time of calculation. It may also be calculated as a cumulative cost of periodical degradation cost of the battery.

2) Battery life span estimation, by considering battery designed life span (i.e., product name plate life span), forecasted life span, or life span limited by overhaul operation. The forecasted life span may be calculated by using battery SoH evolution data.

3) Other costs and revenues as well as their development over the battery life cycle, such as, but not limited to, operational and maintenance cost, battery leasing revenue, carbon emission cost or tax deductions.

4) Battery overhaul cost and its evolution along the battery life cycle. It represents the possible costs and benefits in case of eventual battery overhaul actions. In order to select a battery overhaul action candidate, it may also be necessary to consider the potential overhaul and end of life treatment cost or revenue. This may refer to battery transportation cost, battery recycling cost, or recovered material value. Inclusion or exclusion of certain cost and revenue elements may be determined by the selected business model. For example, in case of battery leasing service provided by owner of a battery fleet, the end-of-life treatment may be undertaken by the battery manufacturer, therefore, no direct cost occurs for battery owner company for the recovery of the raw material value.

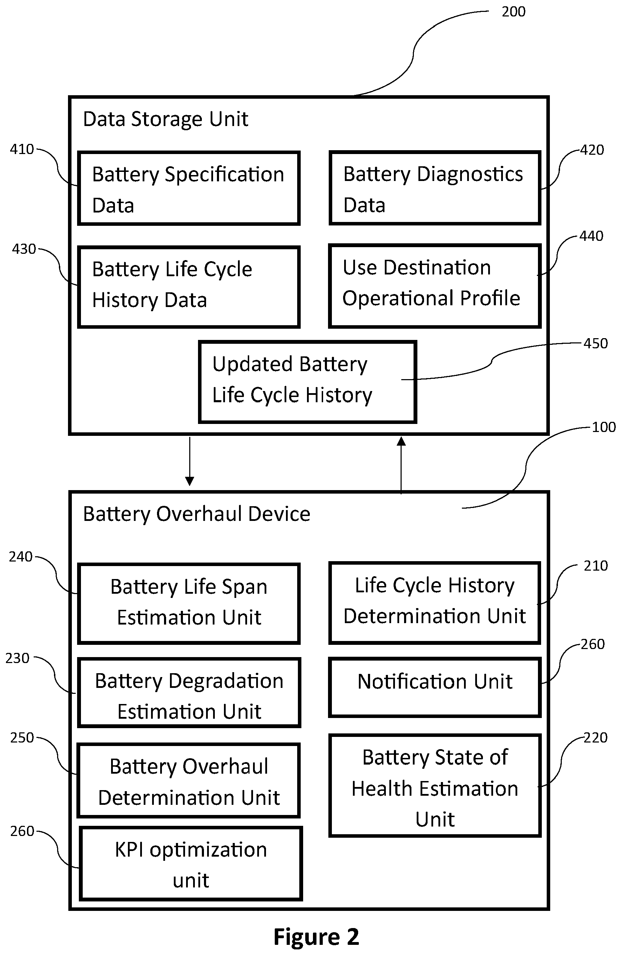

Figure 2 shows a schematic overview over the battery overhaul device 100 in conjunction with a data storage unit 200 according to the present subject-matter. The data storage unit 200 may be an integrated part of the battery overhaul device 100 so that it may also be considered as a system which may be separately claimed by the present application. It may also be connected thereto communicably. The components as previously described are responsible of the selection of a battery overhaul action and determination of the timing of the battery overhaul action. In particular, the battery overhaul device 100 obtains the data required to carry out said selection and determination such as the operational profile 440 of current and possible use destinations 310, 320, battery specification data 410 (e.g., product configuration, cost, nameplate capacity, nameplate life span etc), battery diagnostics data 420 comprising for example a state of charge and life cycle history data 430 or updated battery life cycle history data 450 from the storage unit 200. The storage unit 200 may be a computer-readable medium such as a semiconductor memory device (e.g., a RAM, ROM, PROM, EEPROM, or Flash-Programmable RAM), a magnetic memory device (e.g., a diskette or fixed disk), an optical memory device (e.g., a CD-ROM), a PC card (e.g., PCMCIA card), or other memory device which is either located on an external server or mounted on the facility on which the battery overhaul device 100 is also installed.

For instance, the battery diagnostics data 420 may be provided by a battery control section (not depicted) which controls the necessary electric power supplied to the motor of an electric vehicle from a battery or the power output of a battery operated in a stationary facility. The battery control section measures and monitors, for example, the voltage, input and output currents, a temperature, a state of charge (SOC), and a deterioration state (SOH: State Of Health) of a battery, and transmits these information items to the battery overhaul device 100 through a communication interface. In Figure 2 the communication interface is depicted by the arrows linking the battery overhaul device 100 and the data storage unit 200. The communication interface enables the bilateral communication or data transfer between the battery overhaul device 100 and the data storage unit 200. If a cable is serving as a communication path the battery control section and the storage unit are directly connected. Otherwise, the battery control section is connected to the storage unit through a state-of-the wireless communication link and performs data communication. Here, the state of charge (SoC) is the ratio of a residual capacity to a fully charged capacity, and the deterioration state (SoH: State of Health) is a value representing a state of deterioration of a storage battery calculated from the internal resistance value of the storage battery.

Furthermore, as described above, the battery overhaul device 100 comprises the life cycle determination unit 210 which is configured to obtain life cycle history data including past overhaul actions of a battery of the one or more batteries; the battery state of health estimation unit 220 which is configured to estimate a state of health of the battery, e.g. by receiving the information about the state of health transmitted from the data storage unit 200 or by performing the respective measurements and calculations itself if embodied as a sensor; battery degradation estimation unit 230 configured to estimate a degradation of the battery state of health of the battery, e.g. by being configured to perform the respective and known in the art calculations using the data received from the data storage unit 100; the battery life span estimation unit 240 configured to estimate the battery life span of the battery, e.g. based on the data received from the data storage unit 100 with calculation steps being known in the art; the battery overhaul determination unit 250 which is configured to select at least one battery overhaul action from the battery overhaul action candidates and to determine the timing of the selected battery overhaul action based on, at least one of, the estimated degradation of the battery state of health, the life cycle history data and the estimated battery life span; and the notification unit 260 configured to notify a user of the battery or a system in which the battery is mounted of the selected overhaul action and the determined timing.

The battery degradation estimation unit 230 estimates the battery degradation state and provides the data to the battery state of health estimation unit 220 for calculation of accumulated battery degradation cost. The battery overhaul determination unit 250 selects the possible battery overhaul actions which also comprise applications which may be supported by the battery in its first use destination 310 and a second use destination 320 when the battery overhaul action of repurposing has been selected; these may be preset and stored in a list of options or the like. A KPI optimization unit 260 may provide input to the battery overhaul determination unit 250 to actually perform the selection of the battery overhaul action and the timing thereof, e.g., based on an optimization process which is described further below.

A possible application of a use destination may have requirements such as required energy storage capacity, required operational window (e.g., maximum and minimum SoC), required travelling distance, or required product configuration, potential user demands regarding the functionality of the battery. When the overhaul action of repurposing has been selected by the battery overhaul determination unit, this process is used to pair a current first use destination 310 with a possible second use destination 320 for each battery as depicted in Figure 1. Of course, more than two uses/applications may be "paired" so that the pair would include more than two use phases. For each pair a key performance index (KPI) is calculated and the respective KPIs are compared among each other. With such a comparison, it is possible to determine an optimal pairing of a first battery use destination 310 with a second battery use destination 320 in addition to the selection of a battery overhaul action (in this exemplary case repurposing) and the determination of the timing of the respective battery overhaul action.

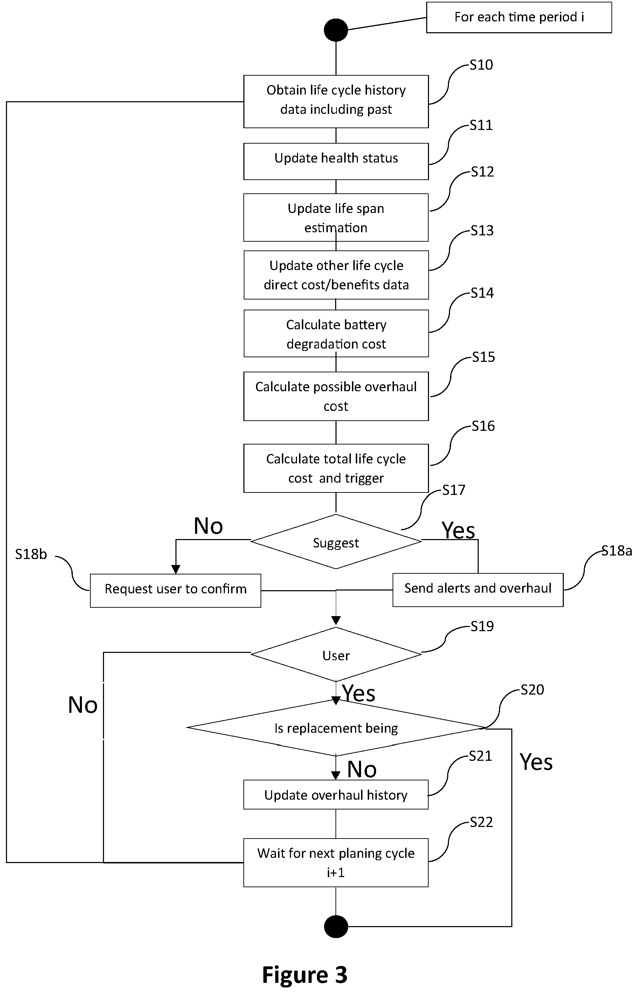

For the case in which a pair of a first use destination 310 and a second use destination 320 (or more) have been determined an exemplary calculation flow is depicted in Figure 3 which may be performed by the respective units of the battery overhaul device 200. The calculation can be triggered regularly, for example, at each planning cycle. It starts by collecting history data of the battery life cycle operations (S10), such as past overhaul actions, history of battery health status, and other data which would be needed to calculate the life cycle KPI, such as but not limited to, battery operation and maintenance data, battery logistics and storage data. Once the data is collected S(11), the battery life span is estimated (S12) and the impact of battery degradation on a target KPI is estimated (S13). The impact of battery degradation on the KPI should not only account for the battery degradation, but also the estimated degradation profile along the life span. In case the target KPI is the life cycle cost, the degradation cost of the battery is calculated (S14) using periodical health status change, and periodical battery purchase cost change. In case a recycling or replacement option is made, a penalty cost will occur as remaining energy storage capacity and material value will be abandoned. In addition, it is possible to calculate the battery residual value from two different portions i.e., the capability of battery to delivery energy storage, and the value of the battery raw material. Whilst the battery storage capability may reduce over time (decrease of battery SoH over time), some raw material may be recycled and its value may be retained, even when the battery storage capability is approaching a value of zero. One simple way to calculate the material value is set to a certain percentage of a new battery purchase value, by considering the type of raw material (e.g., cobalt) and the quantity contained in the battery product.

In addition, it is estimated the relationship between a battery overhaul action and the respective KPI along the estimated life span. In case the target KPI is the life cycle cost, then the cost of the battery overhaul action is calculated (S15). For example, the repurposing cost can be calculated as a function of repurposed battery size and battery health status, as well as transportation and logistics cost. Replacement cost can be calculated as a function of replacement lead time. Remanufacturing cost can be calculated as a function of logistic cost, battery health status and lead time.

Once the life span, degradation cost and potential cost of the selected battery overhaul action have been estimated, the total life cycle cost (KPI) is calculated, by considering all possible battery overhaul actions (cost and time). Optimization is then used, to select among all possible scenarios, the most appropriate options which results in an optimized KPI (S16). It is then decided if a battery overhaul action should be suggested to the user of the battery. The results will be shown to users in the form of alerts and notifications (S18a) or the user is requested to confirm that no battery overhaul action has been selected at the moment (S18b). If the user confirms (S19) and triggers (S20) the selected battery overhaul action, such data will be used as input to the system to recalculate the life span and costs elements in the next calculation interval. If the user does not confirm and trigger the selected battery overhaul action the overhaul history data is updated (S21) and the described optimization process is suspended until a next planning cycle begins (S22). Furthermore, in addition to suspending the optimization process the process flow returns to requesting the step of requesting the user to confirm the selected battery overhaul action (S19). In case the user decides the replace the battery, the battery life will end at the end of the replacement process and total life cycle calculation for a battery is terminated.

Accordingly, the present subject-matter describes an optimization for the technical optimization of battery leasing service for different possible applications such as the provision of energy storage devices for automotive applications and stationary storage applications. During, for example a leasing contract between the battery owner company and a battery user, the battery owner company is responsible to monitoring battery health status, and make overhaul decision in a timely manner, in order to maximize resource efficiency of the energy storage process, life span energy throughput capacity of batteries or the overall cash flow of the leasing model.

As the subject-matter herein at least covers the first and second use destinations 310, 320 of one or more batteries, and that the battery size/configuration may change during its repurposing, it is needed to select or convert the calculation to consistent units e.g. calculation per module, calculation per cell, or calculation per amount of delivered energy. In the calculation example below, a "per module" calculation unit is used.

A detailed modelling method and optimization modelling will be explained in the following paragraphs. More specifically, the successive steps of defining singular inputs, defining vector inputs, defining decision variables, calculating the variables needed for performing the optimization, calculating different cost elements, defining the objective function and defining constraints are discussed in further detail below. In this example, the selected KPI is the annualized benefits of the business, which means, the total amount of life cycle revenue deducted by the total life cycle cost of the battery, assuming a given first and second use destination application (or more than two) and required product characteristics.

It should be noted that, the KPI of other possible implementation may be chosen differently, such as but not limit to, total amount of delivered energy along the life cycle (life span energy throughput), the inflow and outflow of materials (resource efficiency) or total amount of time a battery can be operated (life span).

Corresponding to the above explanations, three preferred and different scenarios for KPI optimization carried out by the battery overhaul device 100 and its subunits, in particular the KPI optimization unit 260, may be preferably described.

The first scenario that will be described is the optimization of a key performance index that has been set to be the net present revenue (NPR).

Definition of singular inputs

| Parameter | Description |
|---|---|
| m | Identification number of the module whose lifecycle should be optimized |
| b | Identification number of the EV battery that contains the module m whose life cycle is to be optimized |
| p | Candidate type of product the repurposed battery will be installed |
| $N_{MpB,FL,b}$ | the number of modules, MpB are the Modules-per-Battery, for first life (FL) contained in b |

(continued)

| Parameter | Description |
|---|---|
| $N_{MPP,SL,P}$ | the number of modules, MpB are the Modules-per-Battery, for second life (SL) contained in p |
| $t_o$ | Purchase time (investment time) of a battery b |
| $j$ | All input data before j is history data, all input data beginning at j are estimated data. |
| $dr_{real}$ | Discount rate |
| $CC_{fix}$ | The initial capital investment costs are occurring at time t = 0 and do not consider the battery purchase cost itself, as battery purchased cost is considered as distributed depreciation cost over time. |
| $SoH_{min,EoFL}$ $SoH_{min,EoL}$ | Minimum SoH threshold for first life (FL) and second life (SL) applications. Typically, it may be the minimum required capacity to support the target application functioning e.g., for automotive application, typically 80% SoH is considered as minimum SoH threshold. |
| $T_{nameplate,b}$ $T_{nameplate,p}$ | Product type plate life span, provided by manufacturer. If such data is not available, a default value may be used. |
| $X_{reman,max}$ $X_{rep,max}$ $X_{repl,max}$ | Optional parameters which sets the maximum number of overhaul which may be considered during battery life. This value may be set for operational reasons of the business operations. |
| $failRate_{c,max}$ | Optional parameters of battery cell fail rate (number of cells which are failed). When set, it is used to define the threshold where remanufacturing or replacement should be triggered. |

Definition of Vector Inputs

Here the term vector input refers to time series data of battery operation, business model corresponding income and cost elements.

| Parameter | Description |
|---|---|
| $RUL_{SoH,FL,t}$ $RUL_{SoH,SL,t}$ | Estimated remaining useful life of the battery in its first or second life operation. This is optional data, as SoH evolution of battery is highly dependant to battery's operational profile, this remaining useful life may be estimated using battery health monitoring and prediction technology. |
| $O\&Mcosta_{FL,t}$ $\forall\, t = j, ... ,$ EoFL_max $O\&Mcosts_{SL,t}$ $\forall\, t = j, ... ,$ EoL | This is operational and maintenance cost of battery dependant to its application. It may or may not be present, dependant to the target business model. |
| $c_{repl\,Fl,t}$ $replTime_b$ | Cost to battery replacement and duration of replacement operation. Battery replacement refers to removing battery and replace with a new one. The removed battery will be recycled. |
| $c_{reman\,Fl,b,t}$ $remanTime_b$ | The remanufacturing cost are also time dependent, so they must be also estimated for each period t and the duration of the remanufacturing process, so the time needed to remanufacture a certain battery b must be also determined. The duration is also time dependent as there might be future technological improvements accelerating for example the disassembly process. It would be possible to add a dependency on the SoH or the failure rate. |
| $C_{rep,p,t}$ $repTime_{b,p}$ | The repurposing costs are time dependent, as well as product dependent because different second life products will require different additional materials or connections. The duration of remanufacturing also depends on the EV-battery type, which will repurposed, and the product being remanufactured, since this determines, for example, the time required for the assembly. |
| $F_{repl,t}$ $F_{reman,t}$ $F_{rep,t}$ $\forall\, t = 0, ... , j$ | History record whether a remanufacturing/replacement/repurposing has been realized at a planning cyle i. This history record is updated every time an overhaul actually happened, the algorithm use it to judge whether total number of overhaul have been reached (if it is set). |

(continued)

| Parameter | Description |
|---|---|
| | Since a process is only considered as done if it has been completed, only the F-values of the respective process at the completion time are 1. The completion time is defined as the period in which the decision variable ($D_{reman,t}$, $D_{rep,t}$, $D_{repl,t}$) associated with the process changes from 0 in period t, to 1 in the next period, where 0 means that a process is being carried out and 1 that the module is in use. |
| $P_t$ | The prices of batteries and their components change over time. This is might be caused for example by the fact that new battery technologies are coming onto the market that have better performance values, and by the evaluation of market prices of the materials used. Accordingly, the respective repurchase prices at different points in time are stored in the vector P with the unit €/module. This vector also reflects the market development. At time t=0, P0 corresponds to the initial purchase costs. |
| $SoH_t$ | The periodically determined state of health of the battery, which is assumed to be the same as that of its modules, is also saved in a vector. |
| $failRate_{c,t}$ | Another factor to determine is the current failure rate of the module. In other words, the maximum proportion of cells in a battery that may have poor performance in relation to the performance of the other cells. |

Definition of Decision Variables

The decision variables are the variables that are returned after the optimization problem has been solved. These are binary variables that are stored in the form of a vector. If the variable assumes the value 0 during a period t, a battery overhaul action of replacement, repurposing or remanufacturing is carried out. As long as the process is running, the respective decision variable stays 0. Otherwise, the variable is assigned the value 1. Decisions can always be made at the current time, i.e., at j. The algorithm therefore is always checking if it would be optimal to carry out a repurposing of a battery at the time of j or if an action is required in form of remanufacturing or replacement, in order to optimize annualized cost. Depending on whether a battery overhaul action should be carried out or not, the respective binary variable then assumes the value 0 or 1.

Binary variable of replacement:

$$D_{repl,t} = \begin{matrix} 0 \ \#\text{replacement} \\ 1 \ \#\text{no replacement} \end{matrix}$$

Binary variable of repurposing:

$$D_{rep,t} = \begin{matrix} 0 \ \#\text{repurposing} \\ 1 \ \#\text{no repurposing} \end{matrix}$$

Binary variable of remanufacturing:

$$D_{reman,t} = \begin{matrix} 0 \ \#\text{remanufacturing} \\ 1 \ \#\text{no remanufacturing} \end{matrix}$$

Calculation of Variables Needed for Optimization

The life cycle history data is marked by an update of the replacement, remanufacturing and repurposing history number. As mentioned above, those are the vector sums of the F-vectors, indicating the competition of the processes.

$$x_{repl,h} = \sum_{t=t\_0}^{j} F_{repl,t}$$

$$x_{reman,h} = \sum_{t=t\_0}^{j} F_{reman,t}$$

$$x_{rep,h} = \sum_{t=t\_0}^{j} F_{rep,t}$$

Estimation of the Battery Life Span

The battery life span not only depicts its functional remaining useful life, but also the time span within which the KPI shall be optimized. Furthermore, it must be defined how long the module could maximally be used for automotive service. This is expressed by the variable EoFL_max, which is given in months. If the maximum service life of a module in a car is predicted to be 8 years, then EoFL_max corresponds to the period t = 96.

The latest point in time at which the module is removed from the car corresponds to the minimum value of the nameplate life predicted by the manufacturer, starting at the time of purchase, or the sum of the months that have passed up to the current point in time and the rest of useful months for the first life application, predicted by the degradation model, or the period at which repurposing (Trep) or replacing (Trepl) starts, as this automatically means the end of the first life.

$$EoFL\_max = \min\left(t_0 + T_{nameplate,b}, j + RUL_{SoH,FL,t}, T_{rep}, T_{repl}\right)$$

In addition to the maximum first service life or time spend at a first use destination 310, the total maximum service life of the module must also be defined, which includes the first and second use destination 320.

The total End-of-Life (EoL) corresponds to the total end-of-life of the battery. Since only two use destinations are assumed in this example it is defined as the minimum of the following three values. The first results from the EoFL_max, which is shown above, including the time required for repurposing and the nameplate life for the second use destination 320. The second value results from the current point in time, in which the battery can already be operated in a second use destination 320, and the predicted rest of useful life. If j is at the second use destination 320, the variable RuL_SoH,SL,t comes into play. The bracketed part has a value of zero since x_rep,h becomes 1 once the module has been repurposed. However, if j is at the first use destination 310, the predicted RuL for the is added to the current period j, as well as the time required for repurposing. The end of life is also notified when the battery and its components are replaced and recycled.

$$EoL_{max} = \min\left( \begin{array}{c} EoFL_{max} + T_{nameplate,p} + repTime_{b,p}, \\ j + RuL_{SoH,SL,t} + \left(repTime_{b,p}\right) \cdot \left(1 - x_{rep,h}\right), \\ T_{repl} \end{array} \right)$$

The calculation time frame starts from j until the end of the battery life.

$$t = [j, EoL\_max]$$

The calculation of the discount factor as a function of t is shown below. It is used to calculate discounted value of each cost element of the target function. It has to be considered that the discount factor must be one at j and that it increases from this point on. The reason therefore is that costs and revenues at the current point in time cannot be discounted to a value at the present time or rather the discount factor must be one at j. Furthermore, the historical values are not discounted either, as they are in the past and in addition to that they are considered to be not relevant for the future decisions and therefore ignored.

$$df_t = \frac{1}{(1 + dr_{real})^t} - \left( \frac{1}{(1 + dr_{real})^j} - 1 \right)$$

The calculation of the capital recovery factor is helpful to calculate the uniform annual cash flows to compare the advantageousness of different opportunities with different lifetimes. *EoL_{max}* - *j* is the number of years under consideration, as it is the number of remaining periods, in which the battery the battery can be used.

$$CRF(dr_{real}, EoL_{max}) = \frac{dr_{real}(1 + dr_{real})^{EoL_{max}-j}}{(1 + dr_{real})^{EoL_{max}-j} - 1}$$

Calculation of Different Cost Elements

This section contains all the calculations that are required to determine the respective cost elements. Starting with the periodic degradation costs, which result from the difference in the salvage values of the module of the periods t-1 and t. The salvage values, in turn, result from the product of the replacement costs prevailing at that point in time and the SoH.

$$pDC_t = S_{t-1} - S_t = P_{t-1} \cdot SoH_{t-1} - P_t \cdot SoH_t$$

The total degradation costs are representing the discounted periodic degradation costs from j on over the remaining life cycle up to the maximum expected usage period plus one.

$$DC_{total} = \sum_{t=j}^{EoL_{max}+1} pDC_t \cdot df_t$$

The plus one results from the fact that the module may reach its EoL before its SoH equals zero. If the sum would only go up to the EoL_max, the penalty costs, which represent the lost value due to the premature recycling of the battery modules, would not be included, but only the periodic degradation costs incurred up to the EoL_max point in time. This is not the case if the end time is set to EoL_max+1. The penalty costs are obtained from the following calculation:

$$pDC_{EoL_{max}+1} = S_{EoL_{max}+1} - S_{EoL_{max}} = p_{EoL_{max}} \cdot SoH_{EoL_{max}} - p_{EoL_{max}+1} \cdot$$
$$SoH_{EoL_{max}+1} = p_{EoL_{max}} \cdot SoH_{EoL_{max}} - 0$$

Here it can also be seen that this term would not be included in the total degradation cost calculation if the sum only went up to EoL_max.

Another binary variable is needed, which provides information about whether the module is in its first or second life or in other words, if it is located at its first use destination (310) or its second use destination (320). This is done for the sake of simplicity, as it reduces the amount of computation that would be required in each period to determine whether x_(rep,h) is already one, i.e. whether the repurposing has already been performed or not. If j is greater than the end-of-first life, the module is in the second life cycle and the binary variable is 0.

$$if\ j \geq EoFL\ \text{then}$$
$$D_{FL} = 0$$

The second cost parameter describes the operations and maintenance costs per module. These vary depending on what the battery is used for. In order to be able to determine the total operation and maintenance costs over the entire life cycle of the module, all periodically occurring operation and maintenance costs from j to the end of life are added up and discounted to the current time using the discount factor. First-life operation and maintenance costs only occur until the End of first life ( $O\&Mcosts_{FL,t}$ ). In other words, as long $as\ j \leq EoFL$ then $D_{FL} = 1$. Operation and maintenance costs of the second life ( $O\&Mcosts_{FL,t}$ ) occur until the module reaches its end of life. The operation and maintenance costs of the second life only occur if $x_{rep,h} = 1$, meaning the repurposing process has been finished and the module is used in its second life application.

$D_{reman,t}$ and $D_{repl,t}$ are the decision variables whether remanufacturing or replacement is ongoing in period t or not, indicated by the values 0 and 1. These decision variables are introduced because operation and maintenance costs are not incurred during remanufacturing and replacement.

Since the operation and maintenance costs are given per battery, they still have to be divided by the number of modules in the EV battery or the number of modules in the battery stationary storage system to get the per module costs.

$$O\&M_{total} = \sum_{t=j}^{EoL} \left( D_{FL} \cdot \frac{O\&Mcosts_{FL,t}}{N_{MpB,FL}} \cdot D_{reman,t} \cdot D_{repl,t} + \left( x_{rep,h} \cdot \frac{O\&Mcosts_{SL,t}}{N_{MpP,SL}} \right) \right) \cdot df_t$$

The concept of battery handling costs combines all discounted costs for replacing or remanufacturing if they incurred between j and EoFL and those for repurposing. Because depending on which of the three takes place, the respective decision variable assumes the value 0 for the duration of the process, which then increases the handling costs. To get the per module values the costs are also divided by the number of modules in the EV battery or the number of modules in the battery stationary storage system.

The if constraint is inserted because handling costs only arise if repurposing is not finished yet, because they are assumed to be considered only during first and not during second life. And as $x_{rep,h}$ stores the number of repurposings performed, which is why it is only zero if repurposing has not been done. *if*

$$x_{rep,h} = 0$$

$$Hdl_{total} = \sum_{j}^{EoFL} \left(1 - D_{repl,t}\right) \cdot \frac{c_{repl\,Fl,b,t}}{N_{MpB,FL}} \cdot df_t + \sum_{j}^{EoFL} \left(1 - D_{reman,t}\right) \cdot \frac{c_{reman\,Fl,b,t}}{N_{MpB,FL}} \cdot df_t$$

$$+ \left(1 - D_{rep,EoFL}\right) \cdot \frac{c_{rep\,p,EoFL}}{N_{MpP,SL}} \cdot df_t$$

The total net present revenues include all revenues from j until end of life and can be calculated like the operation and maintenance costs above. The first life leasing fees are only counted if a battery is in its first life, which is indicated by $D_{FL}$ and not during remanufacturing or replacement. The second life leasing fee is only counted when the module has been repurposed and used in second application. All values are also discounted to get the present values.

$$NPR_{total} = \sum_{t=j}^{EoL} \left( D_{FL} \cdot \frac{leasing\,fee_{FL,t}}{N_{MpB,FL}} \cdot D_{reman,t} \cdot D_{repl,t} + x_{rep,h} \cdot \frac{leasing\,fee_{SL,t}}{N_{MpP,SL}} \right) \cdot df_t$$

Finally, the net present value, given in € per module results from the net present revenues minus the net present costs, consisting of the total degradation costs as well as operation and maintenance costs and handling costs that are generated from the present on.

$$NPV_{total} = NRP_{total} - (DC_{total} + O\&M_{total} + Hdl_{total})$$

Definition of the Objective Function

The objective function represents the function to be optimized. In the present case, the objective function is the maximization of the annualized cash flows, using the above calculated NPV and CRF. Maximization occurs through the selection of the decision variables. Depending on the time or whether it has been decided to do remanufacturing, repurposing or replacing, this has an impact on the end-of-first life or end-of-second life or first use destination (310) and second use destination (320) respectively, which are closely linked.

Decisive for the choice of the decision variables are on one hand the performance of the battery, expressed in form of the SoH and the failing rate, as well as the costs and revenues generated during the two live cycles, but also the market development, which has an influence on the level of costs and revenues.

$$\max CF_{nom,ann} = NPV_{total} \cdot CRF(dr_{real}, EoL_{max})$$

Definition of Constraints

Constraint 1: Only one overhaul process at a time

The first constraint applies to all periods from j up to the latest point in time of the end-of-the first life. It states that replacement, remanufacturing and repurposing cannot take place at the same time, but only one of them or none at all and that neither replacement nor remanufacturing takes place if the failing rate does not exceed the previously defined threshold of failRate_c,max.

$$For\ t\ \in\ (j\,, EoFL_{max}, 1)\ \{$$

$$D_{repl,t} +\ D_{reman,t} + D_{rep,t} \geq 2$$

$$if\ failRate_c <\ failRate_{c,max}$$

$$D_{repl} +\ D_{reman} = 2$$

Constraint 2: Replacement triggers the total end of life

The second constraint states that if replacement takes place, i.e., the decision variable of the replacement becomes zero, the then prevailing period is set equal to the start time of the process. All calculations of this battery will be terminated at this time.

$$If\ D_{repl,t}\ = 0$$

$$T_{repl} = t$$

Constraint 3: Maximum number of overhaul processes

The total number of remanufacturing, replacement and manufacturing must not exceed the maximum value as taken from input.

$$x_{reman.h} \geq x_{reman,max}$$

$$D_{reman,t} = 1$$

$$x_{repl.h} \geq x_{repl,max}$$

$$D_{repl,t} = 1$$

$$x_{rep.h} \geq x_{rep,max}$$

$$D_{rep,t} = 1$$

Constraint 4: Remanufacturing process covering more than one planning cycle

The option of remanufacturing only exists if, the maximum number of remanufacturing processes has not been reached and t is earlier than the end-of-first life or in other words the end of the operation of the battery at a first use destination (310). Assuming these conditions are met and remanufacturing starts, this period t is defined as the beginning of remanufacturing.

When the decision variable $D_{reman,t}$ is set to 0, this value should remain unchanged during the corresponding remanufacturing time, ergo from T_reman until end of remanufacturing process.

$$If \ D_{reman,t} = 0 \ and \ x_{reman.h} \leq x_{reman,max} \ and \ t \leq EoFL_{max} - remanTime\{$$

$$T_{reman} = t$$

$$for \ t \in (T_{reman}, T_{reman} + remanTime)$$

$$D_{reman,t+1} = 0$$

$$or \ else \ \{ D_{reman,t} = 1\}$$

Constraint 5: Repurposing process is covering more than one planning cycle

This constraint resembles the 4th constraint described above, but it applies to repurposing. If repurposing is chosen, t is set to T_rep, which is defined as the starting period of repurposing. This point in time is equal to the period in which the end of first life is reached. Like for the remanufacturing, the decision variable stays zero during repurposing.

$$If \ D_{rep,t} = 0$$

$$T_{rep} = t$$

$$for \ t \in (T_{rep}, T_{rep} + repTime)\{$$

$$D_{rep,t+1} = 0$$

$$\}$$

$$else \ \{ D_{reman,t} = 1\}$$

Constraints 6 and 7: Degradation not recorded within the overhaul process

If the decision variable of remanufacturing D_reman changes from 0 to 1 from one period to another, then the process is finished, whereby F_reman,t is set equal to 1, resulting in an increase of the number of remanufacturing actions performed. Since little or no degradation takes place during remanufacturing, or it is not recorded at all during this time, the periodic degradation costs are calculated as the difference between the value of the module before remanufacturing and after.

$$If \ D_{reman,t} - D_{reman,t-1} = 1$$

$$F_{reman,t} = 1$$

$$pDC_t = P_{t-remanTime} \cdot SoH_{t-remanTime} - P_t \cdot SoH_t$$

$$Else$$

$$F_{reman,t} = 0$$

The same applies to the case of repurposing.

$$If\ D_{rep,t} - D_{rep,t-1} = 1$$

$$F_{rep,t} = 1$$

$$pDC_t = P_{t-repTime} \cdot SoH_{t-repTime} - P_t \cdot SoH_t$$

$$Else$$

$$F_{rep,t} = 0$$

Constraint 8: As already indicated, there is also a constraint that periodic degradation cost should be 0 during the remanufacturing and repurposing.

$$If\ D_{rep,t} = 0$$

$$pDC_t = 0$$

$$If\ D_{reman,t} = 0$$

$$pDC_t = 0$$

The results of the optimization calculation may be shown to users as recommendation and alerts. When a repurposing is recommended and accepted by the user, the battery goes through a repurposing process, and the repurposed battery is subjected to an increase in its state of health

A second scenario that will be described is the optimization of a key performance index that has been set to be the life span energy throughput. Correspondingly the optimization process aims to calculate the best battery overhaul actions and timings to maximize the overall energy delivery and to minimize energy consumption through the overall life span of a battery. As the KPI has been changed from NPV to Total amount of energy throughput capacity, the following parameters have been changed accordingly:

Degradation cost: it represents the loss of energy delivery capacity over a unit of time. Similar to the first scenario, the degradation cost is calculated by replacing the battery purchase price with battery initial capacity in a new or remanufactured state.

Overhaul cost: it represents the amount of energy needed to realize the overhaul operation. As Battery repurposing and remanufacturing would require energy for testing, energy for replacing modules, and energy for operating the manufacturing site. This energy cost would be indirectly handed down to a battery owner who confirms to execute the battery overhaul actions.

Penalty: it is present the amount of energy delivery capacity which would be abandoned in case of battery replacement.

Calculated Variables needed for Optimization

Life time Energy Throughput (KPI)

$$KPI_{total} = \sum_{t=j}^{EoL} DeliveredEnergy_t \cdot df_t$$

Degradation Cost

This variable represents the possible amount of energy that could be delivered in each time unit or each charging/discharging cycle. Penalty refers to the case when a battery is recycled/replaced wherein all remaining energy delivery capacity would be abandoned. It only applies in case of replacement.

$$DC_{total} = \sum_{t=j}^{EoL} pDC_t \cdot df_t + Penalty$$

Total Operation and Management Cost

$$O\&M_{total} = 0$$

Here O&Mt would be set to zero, as regular operation and maintenance activity would not have a direct impact on the energy throughput capacity.

Total Battery Handling Cost

This variable represents the potential gain or loss of energy throughput capacity via different overhaul activities or battery overhaul actions

$$Hdl_{total} = \sum_{j}^{EoL} Hdl_t \cdot df_t$$

$$= \sum_{j}^{EoL} \left( \left(1 - D_{repl,t}\right) \cdot c_{repl\ Fl,b,t} + \left(1 - D_{reman,t}\right) \cdot c_{reman\ Fl,b,t}\right.$$

$$\left. + \left(1 - D_{rep,EoFL}\right) \cdot c_{rep\ p,EoFL}\right) \cdot df_t$$

Total KPI

$$KPI_{total} = \sum_{j}^{EoL} KPI_t = \sum_{j}^{EoL} \left( KPI_t - (DC_t + Hdl_t)\right)$$

$$max\ KPI_{total}$$

Definition of the Objective Function

The objective function represents the function to be optimized. In the present case, the objective function is the maximization of the life span energy throughput capacity, using the above calculated KPI and degradation cost. Maximization occurs through the selection of the decision variables. Depending on the time or whether it has been decided to do remanufacturing, repurposing or replacing, this has an impact on the end-of-first life or end-of-second life or first use destination 310 and second use destination 320 respectively, which are closely linked. It is noted that the constraints described with respect to the first scenario remain the same.

A third scenario that will be described is the optimization of a key performance index that has been set to be material efficiency. In this scenario, the used KPI measures the inflow and outflow material for maintaining the battery operational life including first and second life or first use destination 310 and second use destination 320 respectively.

Similar to as carried out for adapting the process of the first scenario to apply to the second scenario, the following parameters are changed accordingly:

The overhaul cost would be measured as amount of (in flow and outflow material) being used for remanufacturing, repurposing, or recycling. Note that, recycling outflow may be a negative value, as some material would be recovered after recycling.

The degradation cost may become zero as battery degradation will not result in any material losses.

The operation and maintenance cost could be measured as amount of material being replaced/consumed during the operation and maintenance activities.

Definition of the Objective Function

The objective function represents the function to be optimized. In the present case, the objective function is the optimization of material inflow and material outflow, using the above calculated KPI and overhaul cost. Maximization occurs through the selection of the decision variables. Depending on the time or whether it has been decided to do remanufacturing, repurposing or replacing, this has an impact on the end-of-first life or end-of-second life or first use destination 310 and second use destination 320 respectively, which are closely linked. It is noted that the constraints described with respect to the first scenario remain the same.

As will be appreciated by one of skill in the art, the present disclosure, as described hereinabove and the accompanying figures, may be embodied as a method, an apparatus (including a device, machine, system, computer program product, and/or any other apparatus), or a combination of the foregoing.

Accordingly, embodiments of the present disclosure may take the form of an entirely hardware embodiment, an entirely software embodiment (including firmware, resident software, micro-code, etc.), or an embodiment combining software and hardware aspects that may generally be referred to herein as a "system". Furthermore, embodiments of the present disclosure may take the form of a computer program product on a computer-readable medium having computer-executable program code embodied in the medium.

It should be noted that arrows may be used in drawings to represent communication, transfer, or other activity involving two or more entities. Double-ended arrows generally indicate that activity may occur in both directions (e.g., a command/request in one direction with a corresponding reply back in the other direction, or peer-to-peer communications initiated by either entity), although in some situations, activity may not necessarily occur in both directions.

Single-ended arrows generally may indicate activity exclusively or predominantly in one direction, although it should be noted that, in certain situations, such directional activity actually may involve activities in both directions (e.g., a message from a sender to a receiver and an acknowledgement back from the receiver to the sender, or establishment of a connection prior to a transfer and termination of the connection following the transfer). Thus, the type of arrow used in a particular drawing to represent a particular activity is exemplary and should not be seen as limiting.

Aspects are described hereinabove with reference to flowchart illustrations and/or block diagrams of methods and apparatuses, and with reference to a number of sample views of a graphical user interface generated by the methods and/or apparatuses. It will be understood that each block of the flowchart illustrations and/or block diagrams, and/or combinations of blocks in the flowchart illustrations and/or block diagrams, as well as the graphical user interface, can be implemented by computer-executable program code.

The computer-executable program code may be provided to a processor of a general purpose computer, special purpose computer, or other programmable data processing apparatus to produce a particular machine, such that the program code, which executes via the processor of the computer or other programmable data processing apparatus, create means for implementing the functions/acts/outputs specified in the flowchart, block diagram block or blocks, figures, and/or written description.

These computer-executable program code may also be stored in a computer-readable memory that can direct a computer or other programmable data processing apparatus to function in a particular manner, such that the program code stored in the computer readable memory produce an article of manufacture including instruction means which implement the function/act/output specified in the flowchart, block diagram block(s), figures, and/or written description.

The computer-executable program code may also be loaded onto a computer or other programmable data processing apparatus to cause a series of operational steps to be performed on the computer or other programmable apparatus to produce a computer-implemented process such that the program code which executes on the computer or other programmable apparatus provides steps for implementing the functions/acts/outputs specified in the flowchart, block diagram block(s), figures, and/or written description. Alternatively, computer program implemented steps or acts may be combined with operator or human implemented steps or acts in order to carry out an embodiment.

It should be noted that terms such as "server" and "processor" may be used herein to describe devices that may be used in certain embodiments and should not be construed to limit to any particular device type unless the context otherwise requires. Thus, a device may include, without limitation, a bridge, router, bridge-router (b-router), switch, node, server, computer, appliance, or other type of device. Such devices typically include one or more network interfaces for communicating over a communication network and a processor (e.g., a microprocessor with memory and other peripherals and/or application-specific hardware) configured accordingly to perform device functions.

Communication networks generally may include public and/or private networks; may include local-area, wide-area, metropolitan-area, storage, and/or other types of networks; and may employ communication technologies including, but in no way limited to, analogue technologies, digital technologies, optical technologies, wireless technologies (e.g., Bluetooth), networking technologies, and internetworking technologies.

It should also be noted that devices may use communication protocols and messages (e.g., messages created, transmitted, received, stored, and/or processed by the device), and such messages may be conveyed by a communication network or medium.

Unless the context otherwise requires, the present disclosure should not be construed as being limited to any particular communication message type, communication message format, or communication protocol. Thus, a communication message generally may include, without limitation, a frame, packet, datagram, user datagram, cell, or other type of communication message.

Unless the context requires otherwise, references to specific communication protocols are exemplary, and it should be understood that alternative embodiments may, as appropriate, employ variations of such communication protocols (e.g., modifications or extensions of the protocol that may be made from time-to-time) or other protocols either known or developed in the future.

It should also be noted that logic flows may be described herein to demonstrate various aspects and should not be construed to limit the disclosure to any particular logic flow or logic implementation. The described logic may be partitioned into different logic blocks (e.g., programs, modules, functions, or subroutines) without changing the overall results.

Often times, logic elements may be added, modified, omitted, performed in a different order, or implemented using different logic constructs (e.g., logic gates, looping primitives, conditional logic, and other logic constructs) without changing the overall results.

The present disclosure may be embodied in many different forms, including, but in no way limited to, computer program logic for use with a processor (e.g., a microprocessor, microcontroller, digital signal processor, or general purpose computer), programmable logic for use with a programmable logic device (e.g., a Field Programmable Gate Array (FPGA) or other PLD), discrete components, integrated circuitry (e.g., an Application Specific Integrated Circuit (ASIC)), or any other means including any combination thereof Computer program logic implementing some or all of the described functionality is typically implemented as a set of computer program instructions that is converted into a computer executable form, stored as such in a computer readable medium, and executed by a microprocessor under the control of an operating system. Hardware-based logic implementing some or all of the described functionality may be implemented using one or more appropriately configured FPGAs.

Computer program logic implementing all or part of the functionality previously described herein may be embodied in various forms, including, but in no way limited to, a source code form, a computer executable form, and various intermediate forms (e.g., forms generated by an assembler, compiler, linker, or locator).

Source code may include a series of computer program instructions implemented in any of various programming languages (e.g., an object code, an assembly language, or a high-level language such as Fortran, C, C++, JAVA, or HTML) for use with various operating systems or operating environments. The source code may define and use various data structures and communication messages. The source code may be in a computer executable form (e.g., via an interpreter), or the source code maybe converted (e.g., via a translator, assembler, or compiler) into a computer executable form.

Computer-executable program code for carrying out operations of embodiments of the present disclosure may be written in an object oriented, scripted or unscripted programming language such as Java, Perl, Smalltalk, C++, or the like. However, the computer program code for carrying out operations of embodiments may also be written in conventional procedural programming languages, such as the "C" programming language or similar programming languages.

Computer program logic implementing all or part of the functionality previously described herein may be executed at different times on a single processor (e.g., concurrently) or may be executed at the same or different times on multiple processors and may run under a single operating system process/thread or under different operating system processes/threads.

Thus, the term "computer process" may refer generally to the execution of a set of computer program instructions regardless of whether different computer processes are executed on the same or different processors and regardless of whether different computer processes run under the same operating system process/thread or different operating system processes/threads.

The computer program may be fixed in any form (e.g., source code form, computer executable form, or an intermediate form) either permanently or transitorily in a tangible storage medium, such as a semiconductor memory device (e.g., a RAM, ROM, PROM, EEPROM, or Flash-Programmable RAM), a magnetic memory device (e.g., a diskette or fixed disk), an optical memory device (e.g., a CD-ROM), a PC card (e.g., PCMCIA card), or other memory device.

The computer program may be fixed in any form in a signal that is transmittable to a computer using any of various communication technologies, including, but in no way limited to, analog technologies, digital technologies, optical technologies, wireless technologies (e.g., Bluetooth), networking technologies, and internetworking technologies.

The computer program may be distributed in any form as a removable storage medium with accompanying printed or electronic documentation (e.g., shrink wrapped software), preloaded with a computer system (e.g., on system ROM or fixed disk), or distributed from a server or electronic bulletin board over the communication system (e.g., the Internet or World Wide Web).

Hardware logic (including programmable logic for use with a programmable logic device) implementing all or part of the functionality previously described herein may be designed using traditional manual methods, or may be designed, captured, simulated, or documented electronically using various tools, such as Computer Aided Design (CAD), a hardware description language (e.g., VHDL or AHDL), or a PLD programming language (e.g., PALASM, ABEL, or CUPL).

Any suitable computer readable medium may be utilized. The computer readable medium may be, for example but not limited to, an electronic, magnetic, optical, electromagnetic, infrared, or semiconductor system, apparatus, device, or medium.

More specific examples of the computer readable medium include, but are not limited to, an electrical connection having one or more wires or other tangible storage medium such as a portable computer diskette, a hard disk, a random access memory (RAM), a read-only memory (ROM), an erasable programmable read-only memory (EPROM or Flash memory), a compact disc read-only memory (CD-ROM), or other optical or magnetic storage device.

Programmable logic may be fixed either permanently or transitorily in a tangible storage medium, such as a semiconductor memory device (e.g., a RAM, ROM, PROM, EEPROM, or Flash-Programmable RAM), a magnetic memory device (e.g., a diskette or fixed disk), an optical memory device (e.g., a CD-ROM), or other memory device.

The programmable logic may be fixed in a signal that is transmittable to a computer using any of various communication technologies, including, but in no way limited to, analogue technologies, digital technologies, optical technologies, wireless technologies (e.g., Bluetooth), networking technologies, and internetworking technologies.

The programmable logic may be distributed as a removable storage medium with accompanying printed or electronic documentation (e.g., shrink wrapped software), preloaded with a computer system (e.g., on system ROM or fixed disk), or distributed from a server or electronic bulletin board over the communication system (e.g., the Internet or World Wide Web). Of course, some aspects may be implemented as a combination of both software (e.g., a computer program product) and hardware. Still other embodiments of the may be implemented as entirely hardware, or entirely software.

Those skilled in the art will appreciate that combination of the just described embodiments can be configured. For example, unless expressly stated otherwise, the steps of processes described herein may be performed in orders different from those described herein and one or more steps may be combined, split, or performed simultaneously.

Those skilled in the art will also appreciate, in view of this disclosure, that different embodiments or aspects described herein may be combined to form other embodiments.

## Claims

1. A battery overhaul device (100) for monitoring one or more batteries and determining battery overhaul actions for the one or more batteries from a plurality of possible battery overhaul action candidates by using information of the one or more batteries, comprising:

   a life cycle history determination unit (210) configured to obtain life cycle history data including past overhaul actions of a battery of the one or more batteries;
   a battery state of health estimation unit (220) configured to estimate a state of health of the battery;
   a battery degradation estimation unit (230) configured to estimate a degradation of the battery state of health of the battery;
   the battery overhaul device (100) **characterized in that** it further comprises
   a battery life span estimation unit (240) configured to estimate the battery life span of the battery;
   a battery overhaul determination unit (250) configured to select at least one battery overhaul action from the battery overhaul action candidates and to determine the timing of the selected battery overhaul action based on the estimated degradation of the battery state of health, the life cycle history data and the estimated battery life span;
   a notification unit (260) configured to notify a user of the battery or a system in which the battery is mounted of the selected overhaul action and the determined timing, wherein,

   in predetermined planning cycles i:

   the life cycle history determination unit (210) is configured to obtain updated life cycle history data including past overhaul actions of the battery;
   the battery state of health estimation unit (220) is configured to estimate an updated state of health of the battery;
   the battery degradation estimation unit (230) is configured to estimate an updated degradation of the battery state of health of the battery;
   the battery life span estimation (240) unit is configured to estimate the updated battery life span of the battery;
   the battery overhaul determination (250) unit is configured to newly select at least one battery overhaul action from the battery overhaul action candidates and to newly determine the timing of the newly selected battery overhaul action based on the estimated updated degradation of the battery state of health, the updated life cycle history data and the updated estimated battery life span; and
the notification unit (260) is configured to notify the user of the battery or the system in which the battery is mounted of the newly selected overhaul action and the updated determined timing.

2. The battery overhaul device (100) according claim 1, wherein

the candidates for battery overhaul action are predetermined and comprise no battery overhaul action, remanufacturing, replacement including a possible recycling or repurposing of the battery, and
the candidates for battery overhaul actions may be predetermined by a set of candidates for secondary use application.

3. The battery overhaul device (100) according claim 2, wherein
the notification unit (260) is further configured to request confirmation from the notified user or the system on which the battery is mounted if the selected overhaul action is no overhaul action.

4. The battery overhaul device (100) according to claim 2, wherein

if the selected battery overhaul action is another battery overhaul action than no battery overhaul action, the notified user or system on which the battery is mounted is prompted to confirm execution of the selected battery overhaul action,
if the selected battery overhaul action is replacement, the battery overhaul device (200) is configured to terminate the monitoring of the battery, and
if the selected battery overhaul action is neither no battery overhaul action nor replacement, the battery overhaul device (200) is configured to update the life cycle history data of the battery.

5. The battery overhaul device (100) according to at least one of the previous claims, wherein

the battery overhaul determination unit (250) is configured to select a battery overhaul action candidate corresponding to the material inflow which is needed to carry out the battery overhaul action,
the material inflow is as any type of material or component that is needed in order to perform a battery overhaul action,
wherein the battery overhaul action is selected to involve as little material inflow as possible or the least of the different options.

6. The battery overhaul device (100) according to at least one of the previous claims, wherein

the battery overhaul determination unit (250) is configured to select a battery overhaul action candidate corresponding to the change of the state of health of the one or more batteries caused by carrying out the battery overhaul action,
wherein a selection is based on the largest increase of a change of the state of health.

7. The battery overhaul device (100) according to at least one of the previous claims, wherein

the battery overhaul determination unit (250) is configured to select a battery overhaul action candidate corresponding to the life cycle cost of the one or more batteries,
wherein the battery overhaul action is selected on the basis of the lowest or most preferable life cycle cost of the one or more batteries.

8. The battery overhaul device (100) according to at least one of the previous claims, wherein

the battery overhaul determination unit (250) is configured to select a battery overhaul action candidate corresponding to life span energy throughput of the one or more batteries,
wherein a selection of the battery overhaul action candidate is based on the highest life span energy throughput achievable of the different options.

9. The battery overhaul device (100) according to at least one of the previous claims, wherein

the battery overhaul determination unit (250) is configured to determine the timing to perform a battery overhaul action based on the estimated degradation of the battery state of health and a use mode of the battery, wherein the use mode of the battery is an information about a usage frequency of the battery or an amount of discharge in a predetermined period.

10. The battery overhaul device (100) according to at least one of the previous claims, wherein the battery degradation estimation unit (230) is configured to estimate a time at which a battery capacity of the battery reaches a first predetermined value of a minimum required capacity for a current application on the basis of the estimated degradation of the state of health of the battery, and the battery overhaul determination unit (250) is configured to determine the timing to carry out a battery overhaul action when said capacity is reached.

11. The battery overhaul device (100) according to claim 10, wherein when the capacity reaches a first predetermined value of a minimum required capacity for the current application the battery overhaul determination unit (250) is configured to select the battery overhaul action to be remanufacturing, replacement or repurposing of the battery.

12. The battery overhaul device (100) according to claims 10 or 11, wherein

the battery degradation estimation unit (230) is configured to estimate a time at which a battery capacity of the battery reaches a second predetermined value of a minimum required capacity for the current application on the basis of the estimated degradation of the state of health of the battery, and the battery overhaul determination unit (250) is configured to determine the timing to carry out a battery overhaul action when said capacity is reached, wherein the second predetermined value of the minimum required capacity is lower than the first predetermined value of the minimum required capacity.

13. The battery overhaul device (100) according to claim 12, wherein when the capacity reaches a second predetermined value of a minimum required capacity for the current application the battery overhaul determination unit (250) is configured to select the battery overhaul action to be replacement and/or recycling of the battery.

14. The battery overhaul device (100) according to at least one of the previous claims, wherein the battery overhaul action of replacement comprises moving the battery from a first use destination to a second use destination.

15. The battery overhaul device (100) according to at least one of the previous claims, wherein the battery overhaul determination unit (250) is configured to determine whether or not the battery has a state of health determined to be suitable for on-board use based on the estimated degradation of a battery state of health, and to set the second use destination of the battery to a vehicle when the battery is determined be suitable for on-board use.

16. The battery overhaul device (100) according to at least one of the previous claims, wherein the battery overhaul determination unit (250) selects an overhaul action and determines the timing of a selected overhaul action using a KPI optimization unit (260) which performs an optimization process for a key performance factor, including overall life cost, overall benefits, overall energy throughput, or overall material flow, in view of a plurality of combinations of an overhaul action and the timing, and the KPI optimization unit (260) returns to the battery overhaul determination unit (250) for each battery of the one or more batteries one or more battery overhaul actions to be selected during the estimated life span of said battery and the timing of each selected battery overhaul action which return the optimal KPI value.

17. A method for monitoring one or more batteries and determining battery overhaul actions for the one or more batteries from a plurality of possible battery overhaul action candidates by using information of the one or more batteries, comprising the steps to

obtain life cycle history data including past overhaul actions of a battery of the one or more batteries; estimate a state of health of the battery; estimate a degradation of the battery state of health of the battery; the method **characterized in that** it further comprises: estimate the battery life span of the battery; select at least one battery overhaul action from the battery overhaul action candidates and determine the timing of the selected battery overhaul action based on the estimated degradation of the battery state of health, the life cycle history data and the estimated battery life span; and
notify a user of the battery or a system in which the battery is mounted of the selected overhaul action and the determined timing,

wherein,
in predetermined planning cycles i:

obtain updated life cycle history data including past overhaul actions of the battery; estimate an updated state of health of the battery;
estimate an updated degradation of the battery state of health of the battery; estimate the updated battery life span of the battery;
newly select at least one battery overhaul action from the battery overhaul action candidates and to newly determine the timing of the newly selected battery overhaul action based on the estimated updated degradation of the battery state of health, the updated life cycle history data and the updated estimated battery life span; and
notify the user of the battery or the system in which the battery is mounted of the newly selected overhaul action and the updated determined timing.

18. Computer program product configured to carry out the method according to claim 17 when executed on the battery overhaul device of claim 1.

**Patentansprüche**

1. Batterieüberholungsvorrichtung (100) zum Überwachen einer oder mehrerer Batterien und zum Bestimmen von Batterieüberholungsmaßnahmen für die eine oder mehreren Batterien aus mehreren möglichen Batterieüberholungsmaßnahmen-Kandidaten unter Verwendung von Informationen über die eine oder die mehreren Batterien, die Folgendes umfasst:

eine Lebenszyklushistorien-Bestimmungseinheit (210), die konfiguriert ist, Lebenszyklus-Historiendaten, die vergangene Überholungsmaßnahmen enthalten, von einer Batterie der einen oder der mehreren Batterien zu erhalten;
eine Batteriezustands-Schätzeinheit (220), die konfiguriert ist, einen Zustand der Batterie zu schätzen;
eine Batterieverschlechterungs-Schätzeinheit (230), die konfiguriert ist, eine Verschlechterung des Batteriezustands der Batterie zu schätzen;
wobei die Batterieüberholungsvorrichtung (100) **dadurch gekennzeichnet ist, dass** sie ferner Folgendes umfasst:

eine Batterielebensdauer-Schätzeinheit (240), die konfiguriert ist, die Batterielebensdauer der Batterie zu schätzen;
eine Batterieüberholungs-Bestimmungseinheit (250), die konfiguriert ist, mindestens eine Batterieüberholungsmaßnahme aus den Batterieüberholungsmaßnahmen-Kandidaten auszuwählen und die Zeitvorgabe der ausgewählten Batterieüberholungsmaßnahme auf der Grundlage der geschätzten Verschlechterung des Batteriezustands, der Lebenszyklus-Historiendaten und der geschätzten Batterielebensdauer zu bestimmen;
eine Benachrichtigungseinheit (260), die konfiguriert ist, einen Benutzer der Batterie oder ein System, in dem die Batterie angebracht ist, über die ausgewählte Überholungsmaßnahme und die bestimmte Zeitvorgabe zu benachrichtigen,
wobei
in vorgegebenen Planungszyklen i:

die Lebenszyklushistorien-Bestimmungseinheit (210) konfiguriert ist, aktualisierte Lebenszyklus-Historiendaten, die vergangene Überholungsmaßnahmen der Batterie enthalten, zu erhalten;
die Batteriezustands-Schätzeinheit (220) konfiguriert ist, einen aktualisierten Zustand der Batterie zu schätzen;
die Batterieverschlechterungs-Schätzeinheit (230) konfiguriert ist, eine aktualisierte Verschlechterung des Batteriezustands der Batterie zu schätzen;
die Batterielebensdauer-Schätzeinheit (240) konfiguriert ist, die aktualisierte Batterielebensdauer der Batterie zu schätzen;
die Batterieüberholungs-Bestimmungseinheit (250) konfiguriert ist, mindestens eine Batterieüberholungsmaßnahme neu aus den Batterieüberholungsmaßnahmen-Kandidaten auszuwählen und die Zeitvorgabe für die neu ausgewählte Batterieüberholungsmaßnahme auf der Grundlage der geschätzten aktualisierten Verschlechterung des Batteriezustands, der aktualisierten Lebenszyklus-Historiendaten und der aktualisierten geschätzten Batterielebensdauer neu zu bestimmen; und

die Benachrichtigungseinheit (260) konfiguriert ist, den Benutzer der Batterie oder das System, in dem die Batterie angebracht ist, über die neu ausgewählte Überholungsmaßnahme und die aktualisierte bestimmte Zeitvorgabe zu benachrichtigen.

2.  Batterieüberholungsvorrichtung (100) nach Anspruch 1, wobei

die Kandidaten für eine Batterieüberholungsmaßnahme vorgegeben sind und keine Batterieüberholungsmaßnahme, Überarbeitung, Austausch einschließlich einer möglichen Wiederaufbereitung oder einer anderweitigen Verwendung der Batterie umfassen, und
die Kandidaten für Batterieüberholungsmaßnahmen durch eine Gruppe von Kandidaten für eine Anwendung zur sekundären Verwendung vorgegeben sein können.

3.  Batterieüberholungsvorrichtung (100) nach Anspruch 2, wobei
die Benachrichtigungseinheit (260) ferner konfiguriert ist, eine Bestätigung von dem benachrichtigten Benutzer oder dem System, auf dem die Batterie angebracht ist, anzufordern, wenn die ausgewählte Überholungsmaßnahme keine Überholungsmaßnahme ist.

4.  Batterieüberholungsvorrichtung (100) nach Anspruch 2, wobei

dann, wenn die ausgewählte Batterieüberholungsmaßnahme eine andere Batterieüberholungsmaßnahme als keine Batterieüberholungsmaßnahme ist, der benachrichtigte Benutzer oder das benachrichtigte System, auf dem die Batterie angebracht ist, aufgefordert wird, die Ausführung der ausgewählten Batterieüberholungsmaßnahme zu bestätigen,
dann, wenn die ausgewählte Batterieüberholungsmaßnahme ein Austausch ist, die Batterieüberholungsvorrichtung (200) konfiguriert ist, die Überwachung der Batterie zu beenden, und
dann, wenn die ausgewählte Batterieüberholungsmaßnahme weder keine Batterieüberholungsmaßnahme noch Austausch ist, die Batterieüberholungsvorrichtung (200) konfiguriert ist, die Lebenszyklus-Historiendaten der Batterie zu aktualisieren.

5.  Batterieüberholungsvorrichtung (100) nach mindestens einem der vorhergehenden Ansprüche, wobei

die Batterieüberholungs-Bestimmungseinheit (250) konfiguriert ist, einen Batterieüberholungsmaßnahmen-Kandidaten auszuwählen, der dem Materialzufluss, der benötigt wird, um die Batterieüberholungsmaßnahme auszuführen, entspricht,
der Materialzufluss eine beliebige Art von Material oder Komponente ist, die benötigt wird, um eine Batterieüberholungsmaßnahme durchzuführen,
wobei die Batterieüberholungsmaßnahme derart ausgewählt wird, dass ein so geringer Materialzufluss wie möglich oder der geringste der verschiedenen Möglichkeiten eingesetzt wird.

6.  Batterieüberholungsvorrichtung (100) nach mindestens einem der vorhergehenden Ansprüche, wobei

die Batterieüberholungs-Bestimmmungseinheit (250) konfiguriert ist, einen Batterieüberholungsmaßnahmen-Kandidaten auszuwählen, der der Änderung des Zustands der einen oder der mehreren Batterien, die durch das Ausführen der Batterieüberholungsmaßnahme bewirkt wird, entspricht,
wobei eine Auswahl auf einer größten Zunahme einer Änderung des Zustands beruht.

7.  Batterieüberholungsvorrichtung (100) nach mindestens einem der vorhergehenden Ansprüche, wobei

die Batterieüberholungs-Bestimmmungseinheit (250) konfiguriert ist, einen Batterieüberholungsmaßnahmen-Kandidaten auszuwählen, der den Lebenszykluskosten der einen oder der mehreren Batterien entspricht,
wobei die Batterieüberholungsmaßnahme auf der Grundlage der niedrigsten oder am stärksten zu bevorzugenden Lebenszykluskosten der einen oder der mehreren Batterien ausgewählt wird.

8.  Batterieüberholungsvorrichtung (100) nach mindestens einem der vorhergehenden Ansprüche, wobei

die Batterieüberholungs-Bestimmungseinheit (250) konfiguriert ist, einen Batterieüberholungsmaßnahmen-Kandidaten auszuwählen, der einem Lebensdauer-Energiedurchsatz der einen oder der mehreren Batterien entspricht,

wobei eine Auswahl des Batterieüberholungsmaßnahmen-Kandidaten auf dem höchsten Lebensdauer-Energiedurchsatz, der aus den verschiedenen Wahlmöglichkeiten erzielt werden kann, beruht.

9. Batterieüberholungsvorrichtung (100) nach mindestens einem der vorhergehenden Ansprüche, wobei

die Batterieüberholungs-Bestimmungseinheit (250) konfiguriert ist, die Zeitvorgabe, um eine Batterieüberholungsmaßnahme durchzuführen, auf der Grundlage der geschätzten Verschlechterung des Batteriezustands und einer Nutzungsart der Batterie zu bestimmen,

wobei die Nutzungsart der Batterie Informationen über eine Nutzungshäufigkeit der Batterie oder eine Entladungsmenge in einem vorgegebenen Zeitraum sind.

10. Batterieüberholungsvorrichtung (100) nach mindestens einem der vorhergehenden Ansprüche, wobei die Batterieverschlechterungs-Schätzeinheit (230) konfiguriert ist, eine Zeit, zu der eine Batteriekapazität der Batterie einen ersten vorgegebenen Wert einer minimal erforderlichen Kapazität für eine aktuelle Anwendung erreicht, auf der Grundlage der geschätzten Verschlechterung des Zustands der Batterie zu schätzen, und die Batterieüberholungs-Bestimmungseinheit (250) konfiguriert ist, die Zeitvorgabe, um eine Batterieüberholungsmaßnahme auszuführen, als dann, wenn die Kapazität erreicht wird, zu bestimmen.

11. Batterieüberholungsvorrichtung (100) nach Anspruch 10, wobei dann, wenn die Kapazität einen ersten vorgegebenen Wert einer minimal erforderlichen Kapazität für die aktuelle Anwendung erreicht, die Batterieüberholungs-Bestimmungseinheit (250) konfiguriert ist, die Batterieüberholungsmaßnahme derart auszuwählen, dass sie Überarbeitung, Austausch oder anderweitige Verwendung der Batterie ist.

12. Batterieüberholungsvorrichtung (100) nach den Ansprüchen 10 oder 11, wobei

die Batterieverschlechterungs-Schätzeinheit (230) konfiguriert ist, eine Zeit, zu der eine Batteriekapazität der Batterie einen zweiten vorgegebenen Wert einer minimal erforderlichen Kapazität für die aktuelle Anwendung erreicht, auf der Grundlage der geschätzten Verschlechterung des Zustands der Batterie zu schätzen, und die Batterieüberholungs-Bestimmungseinheit (250) konfiguriert ist, die Zeitvorgabe, um eine Batterieüberholungsmaßnahme auszuführen, als dann, wenn die Kapazität erreicht wird, zu bestimmen, wobei der zweite vorgegebene Wert der minimal erforderlichen Kapazität niedriger als der erste vorgegebene Wert der minimal erforderlichen Kapazität ist.

13. Batterieüberholungsvorrichtung (100) nach Anspruch 12, wobei dann, wenn die Kapazität einen zweiten vorgegebenen Wert einer minimal erforderlichen Kapazität für die aktuelle Anwendung erreicht, die Batterieüberholungs-Bestimmungseinheit (250) konfiguriert ist, die Batterieüberholungsmaßnahme derart auszuwählen, dass sie Austausch und/oder Wiederaufbereitung der Batterie ist.

14. Batterieüberholungsvorrichtung (100) nach mindestens einem der vorhergehenden Ansprüche, wobei die Batterieüberholungsmaßnahme des Austauschs das Bewegen der Batterie von einem ersten Verwendungsbestimmungsort zu einem zweiten Verwendungsbestimmungsort umfasst.

15. Batterieüberholungsvorrichtung (100) nach mindestens einem der vorhergehenden Ansprüche, wobei die Batterieüberholungs-Bestimmungseinheit (250) konfiguriert ist, auf der Grundlage der geschätzten Verschlechterung eines Batteriezustands zu bestimmen, ob die Batterie einen Zustand, für den bestimmt wird, dass er zur Verwendung an Bord geeignet ist, aufweist oder nicht, und den zweiten Verwendungsbestimmungsort der Batterie auf ein Fahrzeug einzustellen, wenn bestimmt wird, dass die Batterie für die Verwendung an Bord geeignet ist.

16. Batterieüberholungsvorrichtung (100) nach mindestens einem der vorhergehenden Ansprüche, wobei

die Batterieüberholungs-Bestimmungseinheit (250) eine Überholungsmaßnahme auswählt und die Zeitvorgabe einer ausgewählten Überholungsmaßnahme unter Verwendung einer KPI-Optimierungseinheit (260) bestimmt, die einen Optimierungsprozess für eine Schlüsselleistungskennzahl, die die Gesamtlebensdauerkosten, den Gesamtnutzen, den Gesamtenergiedurchsatz oder den Gesamtmaterialfluss enthält, in Hinblick auf mehrere Kombinationen einer Überholungsmaßnahme und der Zeitvorgabe durchführt, und

die KPI-Optimierungseinheit (260) an die Batterieüberholungs-Bestimmungseinheit (250) für jede Batterie der einen oder der mehreren Batterien eine oder mehrere Batterieüberholungsmaßnahmen, die während der geschätzten Lebensdauer der Batterie ausgewählt werden sollen, und die Zeitvorgabe jeder ausgewählten Batterieüberholungsmaßnahme, die den optimalen KPI-Wert zurückgeben, zurückgibt.

17. Verfahren zum Überwachen einer oder mehrerer Batterien und zum Bestimmen von Batterieüberholungsmaßnahmen für die eine oder mehreren Batterien aus mehreren möglichen Batterieüberholungsmaßnahmen-Kandidaten unter Verwendung von Informationen über die eine oder mehreren Batterien, das die folgenden Schritte umfasst:

Erhalten von Lebenszyklus-Historiendaten, die vergangene Überholungsmaßnahmen enthalten, einer Batterie der einen oder der mehreren Batterien;
Schätzen eines Zustands der Batterie;
Schätzen einer Verschlechterung des Batteriezustands der Batterie;
wobei das Verfahren **dadurch gekennzeichnet ist, dass** es ferner Folgendes umfasst:

Schätzen der Batterielebensdauer der Batterie;
Auswählen mindestens einer Batterieüberholungsmaßnahme aus den Batterieüberholungsmaßnahmen-Kandidaten und Bestimmen der Zeitvorgabe der ausgewählten Batterieüberholungsmaßnahme auf der Grundlage der geschätzten Verschlechterung des Batteriezustands, der Lebenszyklus-Historiendaten und der geschätzten Batterielebensdauer; und
Benachrichtigen eines Benutzers der Batterie oder eines Systems, in dem die Batterie angebracht ist, über die ausgewählte Überholungsmaßnahme und die bestimmte Zeitvorgabe,
wobei
in vorgegebenen Planungszyklen i:

Erhalten von aktualisierten Lebenszyklus-Historiendaten, die vergangene Überholungsmaßnahmen der Batterie enthalten;
Schätzen eines aktualisierten Zustands der Batterie;
Schätzen einer aktualisierten Verschlechterung des Batteriezustands der Batterie;
Schätzen der aktualisierten Batterielebensdauer der Batterie;
Neuauswählen mindestens einer Batterieüberholungsmaßnahme aus den Batterieüberholungsmaßnahmen-Kandidaten und Neubestimmen der Zeitvorgabe der neu ausgewählten Batterieüberholungsmaßnahme auf der Grundlage der geschätzten aktualisierten Verschlechterung des Batteriezustands, der aktualisierten Lebenszyklus-Historiendaten und der aktualisierten geschätzten Batterielebensdauer; und
Benachrichtigen des Benutzers der Batterie oder des Systems, in dem die Batterie angebracht ist, über die neu ausgewählte Überholungsmaßnahme und die aktualisierte bestimmte Zeitvorgabe.

18. Computerprogrammprodukt, das konfiguriert ist, das Verfahren nach Anspruch 17 auszuführen, wenn es auf der Batterieüberholungsvorrichtung nach Anspruch 1 ausgeführt wird.

## Revendications

1. Système de reconditionnement de batterie (100) destiné à surveiller une ou plusieurs batteries et à déterminer des actions de reconditionnement de batterie pour lesdites une ou plusieurs batteries à partir d'une pluralité d'actions candidates possibles de reconditionnement de batterie à l'aide d'informations concernant lesdites une ou plusieurs batteries, comprenant :

une unité de détermination d'historique de cycle de vie (210) configurée pour obtenir des données d'historique de cycle de vie incluant des actions de reconditionnement passées d'une batterie parmi lesdites une ou plusieurs batteries ;
une unité d'estimation d'état de santé de batterie (220) configurée pour estimer un état de santé de la batterie ;
une unité d'estimation de dégradation de batterie (230) configurée pour estimer une dégradation de l'état de santé de batterie de la batterie ;
le dispositif de reconditionnement de batterie (100) étant **caractérisé en ce qu'**il comprend en outre
une unité d'estimation de durée de vie de batterie (240) configurée pour estimer la durée de vie de batterie de la batterie,

une unité de détermination de reconditionnement de batterie (250) configurée pour sélectionner au moins une action de reconditionnement de batterie parmi des actions candidates de reconditionnement de batterie et pour déterminer la temporisation de l'action de reconditionnement de batterie sélectionnée sur la base de la dégradation estimée de l'état de santé de batterie, des données d'historique de cycle de vie, et de la durée de vie de batterie estimée ;

une unité de notification (260) configurée pour avertir un utilisateur de la batterie ou un système dans lequel est montée la batterie de l'action de reconditionnement sélectionnée et de la temporisation déterminée, dans lequel dans des cycles de planification prédéterminés i :

l'unité de détermination d'historique de cycle de vie (210) est configurée pour obtenir des données d'historique de cycle de vie mises à jour incluant des actions de reconditionnement passées de la batterie ;

l'unité d'estimation d'état de santé de batterie (220) est configurée pour estimer un état de santé mis à jour de la batterie ;

l'unité d'estimation de dégradation de batterie (230) est configurée pour estimer une dégradation mise à jour de l'état de santé de batterie de la batterie ;

l'unité d'estimation de durée de vie de batterie (240) est configurée pour estimer la durée de vie de batterie mise à jour de la batterie ;

l'unité de détermination de reconditionnement de batterie (250) est configurée pour sélectionner nouvellement au moins une action de reconditionnement de batterie parmi des actions candidates de reconditionnement de batterie et pour déterminer nouvellement la temporisation de l'action de reconditionnement de batterie nouvellement sélectionnée sur la base de la dégradation mise à jour de l'état de santé de batterie estimée, des données d'historique de cycle de vie mises à jour, et

de la durée de vie de batterie estimée mise à jour ; et

l'unité de notification (260) est configurée pour avertir l'utilisateur de la batterie ou le système dans lequel est montée la batterie de l'action de reconditionnement nouvellement sélectionnée et de la temporisation déterminée mise à jour.

2. Dispositif de reconditionnement de batterie (100) selon la revendication 1, dans lequel

les actions candidates pour l'action de reconditionnement de batterie sont prédéterminées et ne comprennent aucune action de reconditionnement de batterie, de refabrication, de remplacement incluant un possible recyclage ou une possible reconversion de la batterie, et

les actions candidates pour les actions candidates de reconditionnement de batterie peuvent être prédéterminées par un ensemble d'actions candidates pour une application d'usage secondaire.

3. Dispositif de reconditionnement de batterie (100) selon la revendication 2, dans lequel
l'unité de notification (260) est en outre configurée pour requérir une confirmation de l'utilisateur notifié ou du système notifié sur lequel est montée la batterie si l'action de reconditionnement sélectionnée n'est pas une action de reconditionnement.

4. Dispositif de reconditionnement de batterie (100) selon la revendication 2, dans lequel

si l'action de reconditionnement de batterie sélectionnée est une action de reconditionnement de batterie autre qu'aucune action de reconditionnement de batterie, l'utilisateur notifié ou le système notifié sur lequel est montée la batterie est invité à confirmer une exécution de l'action de reconditionnement de batterie sélectionnée,

si l'action de reconditionnement de batterie sélectionnée est un remplacement, le dispositif de reconditionnement de batterie (200) est configuré pour terminer la surveillance de la batterie, et

si l'action de reconditionnement de batterie sélectionnée n'est ni aucune action de reconditionnement de batterie, ni un remplacement, le dispositif de reconditionnement de batterie (200) est configuré pour mettre à jour les données d'historique de cycle de vie de la batterie.

5. Dispositif de reconditionnement de batterie (100) selon l'une au moins des revendications précédentes, dans lequel

l'unité de détermination de reconditionnement de batterie (250) est configurée pour sélectionner une action candidate de reconditionnement de batterie correspondant au flux entrant de matériau qui est nécessaire pour exécuter l'action de reconditionnement de batterie,

le flux entrant de matériau est d'un type de matériau ou de composant quelconque qui est nécessaire afin d'effectuer une action de reconditionnement de batterie,

dans lequel l'action de reconditionnement de batterie est sélectionnée pour impliquer aussi peu de flux entrant de matériau que possible ou le minimum d'options différentes.

6.  Dispositif de reconditionnement de batterie (100) selon l'une au moins des revendications précédentes, dans lequel

    l'unité de détermination de reconditionnement de batterie (250) est configurée pour sélectionner une action candidate de reconditionnement de batterie correspondant au changement de l'état de santé desdites une ou plusieurs batteries entraîné en exécutant l'action de reconditionnement de batterie,
    dans lequel une sélection est basée sur la plus grande augmentation d'un changement de l'état de santé.

7.  Dispositif de reconditionnement de batterie (100) selon l'une au moins des revendications précédentes, dans lequel

    l'unité de détermination de reconditionnement de batterie (250) est configurée pour sélectionner une action candidate de reconditionnement de batterie correspondant au coût de cycle de vie desdites une ou plusieurs batteries,
    dans lequel l'action de reconditionnement de batterie est sélectionnée sur la base du coût de cycle de vie le plus bas ou le plus préférable desdits unes ou plusieurs batteries.

8.  Dispositif de reconditionnement de batterie (100) selon l'une au moins des revendications précédentes, dans lequel

    l'unité de détermination de reconditionnement de batterie (250) est configurée pour sélectionner une action candidate de reconditionnement de batterie correspondant à un rendement énergétique de durée de vie desdites une ou plusieurs batteries,
    dans lequel une sélection de l'action candidate de reconditionnement de batterie est basée sur le rendement énergétique de durée de vie le plus élevé pouvant être atteint parmi les différentes options.

9.  Dispositif de reconditionnement de batterie (100) selon l'une au moins des revendications précédentes, dans lequel

    l'unité de détermination de reconditionnement de batterie (250) est configurée pour déterminer la temporisation pour effectuer une action de reconditionnement de batterie sur la base de la dégradation estimée de l'état de santé de batterie et d'un mode utilisation de la batterie,
    dans lequel le mode d'utilisation de la batterie est une information concernant une fréquence d'usage de la batterie ou une amplitude de décharge dans une période prédéterminée.

10. Dispositif de reconditionnement de batterie (100) selon l'une au moins des revendications précédentes, dans lequel l'unité d'estimation de dégradation de batterie (230) est configurée pour estimer un temps auquel une capacité de batterie de la batterie atteint une première valeur prédéterminée d'une capacité minimum requise pour une application actuelle sur la base de la dégradation estimée de l'état de santé de la batterie, et l'unité de détermination de reconditionnement de batterie (250) est configurée pour déterminer la temporisation pour exécuter une action de reconditionnement de batterie quand ladite capacité est atteinte.

11. Dispositif de reconditionnement de batterie (100) selon la revendication 10, dans lequel quand la capacité atteint une première valeur prédéterminée capacité minimum requise pour l'application actuelle, l'unité de détermination de reconditionnement de batterie (250) est configurée pour sélectionner l'action de reconditionnement de batterie comme étant une refabrication, un remplacement ou une reconversion de la batterie.

12. Dispositif de reconditionnement de batterie (100) selon la revendication 10 ou 11, dans lequel

    l'unité d'estimation de dégradation de batterie (230) est configurée pour estimer un temps auquel une capacité de batterie de la batterie atteint une seconde valeur prédéterminée d'une capacité minimum requise pour l'application actuelle sur la base de la dégradation estimée de l'état de santé de la batterie, et l'unité de détermination de reconditionnement de batterie (250) est configurée pour déterminer la temporisation pour exécuter une action de reconditionnement de batterie quand ladite capacité est atteinte,
    dans lequel la seconde valeur prédéterminée de la capacité minimum requise est inférieure à une première valeur prédéterminée de la capacité minimum requise.

13. Dispositif de reconditionnement de batterie (100) selon la revendication 12, dans lequel quand la capacité atteint une seconde valeur prédéterminée d'une capacité minimum requise pour l'application actuelle, l'unité de détermination de reconditionnement de batterie (250) est configurée pour sélectionner l'action de reconditionnement de batterie comme étant un remplacement et/ou un recyclage de la batterie.

14. Dispositif de reconditionnement de batterie (100) selon l'une au moins des revendications précédentes, dans lequel l'action de reconditionnement de batterie de remplacement comprend de faire passer la batterie d'une première destination d'utilisation à une seconde destination d'utilisation.

15. Dispositif de reconditionnement de batterie (100) selon l'une au moins des revendications précédentes, dans lequel l'unité de détermination de reconditionnement de batterie (250) est configurée pour déterminer si oui ou non la batterie a un état de santé déterminé comme étant acceptable pour une utilisation à bord sur la base de la dégradation estimée d'un état de santé de batterie, et pour fixer la seconde destination d'utilisation de la batterie pour un véhicule quand la batterie est déterminée comme étant acceptable pour une utilisation à bord.

16. Dispositif de reconditionnement de batterie (100) selon l'une au moins des revendications précédentes,

dans lequel l'unité de détermination de reconditionnement de batterie (250) sélectionne une action de reconditionnement et détermine la temporisation d'une action de reconditionnement sélectionnée à l'aide d'une unité d'optimisation KPI (260) qui effectue un processus d'optimisation pour un indicateur de performance clé, incluant un coût de vie global, des bénéfices globaux, des rendements énergétiques globaux, ou un flux de matériau global, en vue d'une pluralité de combinaisons d'une action de reconditionnement et de la temporisation, et l'unité d'optimisation KPI (260) renvoie à l'unité de détermination de reconditionnement de batterie (250) pour chaque batterie desdites une ou plusieurs batteries, une ou plusieurs actions de reconditionnement de batterie devant être sélectionnées pendant la durée de vie estimée de ladite batterie et la temporisation de chaque action de reconditionnement de batterie sélectionnée qui renvoie à la valeur KPI optimale.

17. Procédé de surveillance d'une ou de plusieurs batteries et de détermination d'actions candidates de reconditionnement de batterie pour lesdites une ou plusieurs batteries à partir d'une pluralité d'actions candidates possibles de reconditionnement de batterie à l'aide d'informations concernant lesdites une ou plusieurs batteries, comprenant les étapes consistant à

obtenir des données d'historique de cycle de vie incluant des actions de reconditionnement passées d'une batterie parmi lesdites une ou plusieurs batteries ;
estimer un état de santé de la batterie ;
estimer une dégradation de l'état de santé de batterie de la batterie ;
le dispositif de reconditionnement de batterie (100) étant **caractérisé en ce qu'**il comprend en outre
le procédé étant **caractérisé en ce qu'**il comprend en outre les étapes consistant à :

estimer la durée de vie de batterie de la batterie ;
sélectionner au moins une action de reconditionnement de batterie parmi des actions candidates de reconditionnement de batterie et déterminer la temporisation de l'action de reconditionnement de batterie sélectionnée sur la base de la dégradation estimée de l'état de santé de batterie, des données d'historique de cycle de vie, et de la durée de vie de batterie estimée ; et
avertir un utilisateur de la batterie ou un système dans lequel est montée la batterie de l'action de reconditionnement sélectionnée et de la temporisation déterminée,
dans lequel le procédé comprend les étapes consistant à,
dans des cycles de planification prédéterminés i :

obtenir des données d'historique de cycle de vie mises à jour incluant des actions de reconditionnement passées de la batterie ;
estimer un état de santé mis à jour de la batterie ;
estimer une dégradation mise à jour de l'état de santé de batterie de la batterie ;
estimer la durée de vie de batterie mise à jour de la batterie ;
sélectionner nouvellement au moins une action de reconditionnement de batterie parmi des actions candidates de reconditionnement de batterie et déterminer nouvellement la temporisation de l'action de reconditionnement de batterie nouvellement sélectionnée sur la base de la dégradation mise à jour estimée de l'état de santé de batterie, des données d'historique de cycle de vie mises à jour, et de la durée de vie de batterie estimée mise à jour ; et avertir l'utilisateur de la batterie ou le système dans lequel est montée la batterie de l'action de reconditionnement nouvellement sélectionnée et de la temporisation déterminée mise à jour.

18. Produit de programme d'ordinateur configuré pour exécuter le procédé selon la revendication 17 quand il est exécuté sur le dispositif de reconditionnement de batterie selon la revendication 1.

Figure 1

200

## Data Storage Unit

410
**Battery Specification Data**

420
**Battery Diagnostics Data**

430
**Battery Life Cycle History Data**

440
**Use Destination Operational Profile**

450
**Updated Battery Life Cycle History**

100

## Battery Overhaul Device

240
**Battery Life Span Estimation Unit**

210
**Life Cycle History Determination Unit**

230
**Battery Degradation Estimation Unit**

260
**Notification Unit**

250
**Battery Overhaul Determination Unit**

220
**Battery State of Health Estimation Unit**

260
**KPI optimization unit**

**Figure 2**

Figure 3

**REFERENCES CITED IN THE DESCRIPTION**

**Patent documents cited in the description**

- EP 3026751 B1
- US 2020326382 A1
- US 2021081875 A
- US 2023242009 A
- US 2023011148 A1